# EUROPEAN PATENT SPECIFICATION

(11) **EP 1 930 392 B1**
(45) Date of publication and mention of the grant of the patent: **10.04.2013**
(21) Application number: 06796409.8
(22) Date of filing: 14.08.2006
(51) Int. Cl.: C09K 11/06, C09D 11/00, H01L 51/42, H01L 51/50

(54) **LIGHT-EMITTING MATERIAL CONTAINING METAL COMPLEX AND PHOTOELECTRIC DEVICE USING SAME**
LICHTEMITTIERENDES MATERIAL MIT METALLKOMPLEX SOWIE DAVON GEBRAUCH MACHENDE PHOTOELEKTRISCHE VORRICHTUNG
MATÉRIAU ÉMETTEUR DE LUMIÈRE CONTENANT UN COMPLEXE MÉTALLIQUE ET DISPOSITIF PHOTOÉLECTRIQUE L UTILISANT

(30) Priority: 15.08.2005 JP 2005235141
(43) Date of publication of application: 11.06.2008
(73) Proprietor: Sumitomo Chemical Company, Limited, Tokyo 104-8260 (JP)
(72) Inventor: TSUBOMURA, Taro, Tokyo 1808633 (JP); SEKINE, Chizu, Ibaraki 3004249 (JP)
(74) Representative: Benson, John Everett
(86) International application number: PCT/JP2006/316019
(87) International publication number: WO 2007/020915

(56) References cited:
- WO-A1-02/15645
- WO-A1-02/15645
- WO-A1-2004/104136
- WO-A2-03/091688
- JP-A- 2005 220 351
- KR-A- 20050 077 366
- ZAINUL ABEDIN-SIDDIQUE, TAKESHI OHNO, KOICHI NOZAKI: "Intense Fluorescence of Metal-to-Ligand Charge Transfer in [Pt(0)(binap)2] [binap ) 2,2'-Bis(diphenylphosphino)-1,1'-binaphthy l]" INORGANIC CHEMISTRY, vol. 43, 16 December 2003 (2003-12-16), pages 663-673, XP002569144
- T. TSUBOMURA, M. ABE, M. TARUTANI, H. YAMADA, T. TSUKUDA: "Photophysical and Photochemical Studies of [Pt(binap)2]: Excited State Quenching by Oxygen" BULL. CHEM. SOC. JPN., vol. 76, 15 November 2003 (2003-11-15), pages 2151-2152, XP002569200

## Description

### TECHNICAL FIELD

The present invention relates to a photoelectric device such as an organic electroluminescent device used in a display device or a photoelectric conversion device used in a solar cell, and to a material used in the same.

### BACKGROUND ART

Various metal complex compounds have heretofore been used as light-emitting materials, charge-transporting materials, and the like, for photoelectric devices.
For example, metal complexes that exhibit light emission from a triplet excited state have been studied as light-emitting materials used for light-emitting layers in organic electroluminescent (EL) light-emitting devices. It has been known that ortho-metalated complexes comprising Ir as a central metal exhibit high light-emitting efficiency (Non-Patent Document 1).

Alternatively, a substantially ionic organic metal compound has been known, which comprises: a heavy transition metal that emits a phosphorescent light at room temperature; at least one monoanionic bidentate, carbon-coordination ligand bound to the heavy transition metal; and at least one non-monoanionic bidentate, carbon-coordination ligand bound to the heavy transition metal (Patent Document 1).
Alternatively, a platinum complex has also been known, which comprises Pt(II) to which only one bidentate ligand containing a phosphorus atom is coordinated (Patent Document 2).
Non-Patent Document 1: APPLIED PHYSICS LETTERS, 75, 1, 4, (1999)
Patent Document 1: WO02/15645 A1
Patent Document 2: WO2005/056712 A1

WO 03/091688 discloses a metal complex in a low-molecualar - weight organic compound.

### DISCLOSURE OF THE INVENTION

### Problem to be Solved by the Invention

However, for example, ortho-metalated complexes comprising Ir as a central metal require high temperatures for their synthesis. Because of such difficulties in synthesis and low yields, the ortho-metalated complexes presented such problems that it is not easy to obtain large amounts of these complexes and materials containing them.

An object of the present invention is to provide a metal complex material that offers easy synthesis and favorable photoelectric characteristics and to provide a photoelectric device using the same. Means for Solving the Problem

Specifically, the present invention is as defined in the claims.

### BEST MODE FOR CARRYING OUT THE INVENTION

Hereinafter, the present invention will be described in detail.
First, the present invention relates to a material characterized by containing a neutral metal complex or a structure of the metal complex, the neutral metal complex having a partial structure represented by the general formula (1) below and at least two multidentate ligands, and having charge-transporting properties: 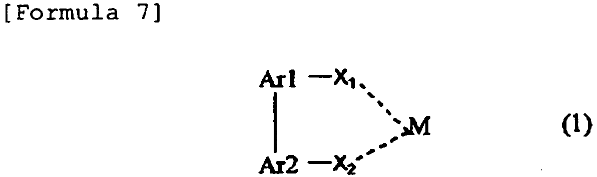 (in the formula, M represents a transition metal or a lanthanoid; Ar1 and Ar2 each independently represent an optionally substituted divalent aromatic ring; and X₁ and X₂ each independently represent P(Ar3)(Ar4), S, or O. In this connection, Ar3 and Ar4 each independently represent an optionally substituted monovalent aromatic ring. The broken line in the formula represents a coordinate bond between a multidentate ligand and the metal).
First, the metal complex used in the present invention will be described.
The metal complex has the partial structure represented by the general formula (1). The metal M in the formula (1) is a metal selected from a transition metal and a lanthanoid. Specific examples thereof include Sc, Ti, Cr, Mn, Fe, Co, Ni, Cu, Zn, Y, Zr, Nb, Mo, Tc, Ru, Rh, Pd, Ag, Hf, Ta, W, Os, Ir, Pt, Au, La, Ce, Pr, Nd, Pm, Sm, Eu, Gd, Tb, Dy, Ho, Er, Tm, Yb, and Lu. Ru, Rh, Pd, W, Ir, Pt, and Au are preferable from the viewpoint of obtaining high efficiency.

X₁ and X₂ in the formula (1) each independently represent P(Ar3)(Ar4), S, or O. Thus, an atom coordinated to the metal M is any of P, O, and S. P is preferable from the viewpoint of light-emitting efficiency.
Ar3 and Ar4 in the formula (1) each independently represent an optionally substituted monovalent aromatic ring. Specific examples thereof include a phenyl group, a biphenyl group, a naphthyl group, a pyridyl group, and a pyrimidyl group.
Ar1 and Ar2 in the formula (1) each independently represent an optionally substituted divalent aromatic ring. Examples of the aromatic ring include an aromatic hydrocarbon ring and a heteroaromatic ring. The aromatic ring may be a monocyclic ring or may be a condensed ring. Specific examples thereof include a phenylene group, a biphenylene group, a naphthylene group, a pyridylene group, and a pyrimidylene group. Ar1 and Ar2 are bonded to each other.
The substituents by which Ar1, Ar2, Ar3, and Ar4 are optionally substituted are not particularly limited and are exemplified by a halogen atom, an alkyl group, an alkenyl group, an alkynyl group, an aryl group, an alkoxy group, an aryloxy group, an alkylthio group, an arylthio group, an arylalkyl group, an arylalkyloxy group, an arylalkylthio group, an acyl group, an acyloxy group, a monovalent heterocyclic group, a heteroaryloxy group, a heteroarylthio group, an arylalkenyl group, and an arylethynyl group.

Examples of the halogen atom include a fluorine atom, a chlorine atom, a bromine atom, and an iodine atom.

The alkyl group may be linear, branched, or cyclic. The alkyl group usually has approximately 1 to 10 carbon atoms, preferably 3 to 10 carbon atoms. Specific examples thereof include a methyl group, an ethyl group, a propyl group, an isopropyl group, a butyl group, an isobutyl group, a t-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, and a perfluorooctyl group. A pentyl group, a hexyl group, an octyl group, a 2-ethylhexyl group, a decyl group, and a 3,7-dimethyloctyl group are preferable.

The alkenyl group may be linear, branched, or cyclic. The alkenyl group usually has approximately 2 to 10 carbon atoms, preferably 3 to 10 carbon atoms. Specifically, an ethenyl group, a propenyl group, a butenyl group, a pentenyl group, a hexenyl group, a heptenyl group, and an octenyl group are preferable.

The alkynyl group may be linear, branched, or cyclic. The alkynyl group usually has approximately 2 to 10 carbon atoms, preferably 3 to 10 carbon atoms. Specifically, an ethynyl group, a propynyl group, a butynyl group, a pentynyl group, a hexynyl group, a heptynyl group, and an octynyl group are preferable.

The aryl group usually has approximately 6 to 60 carbon atoms, preferably 7 to 48 carbon atoms. Specific examples thereof include a phenyl group, a C₁ to C₁₂ alkoxyphenyl group (C₁ to C₁₂ represent 1 to 12 carbon atoms, respectively. The same holds true for the descriptions below), a C₁ to C₁₂ alkylphenyl group, a 1-naphthyl group, a 2-naphthyl group, a 1-anthracenyl group, a 2-anthracenyl group, a 9-anthracenyl group, and a pentafluorophenyl group. A C₁ to C₁₂ alkoxyphenyl group and a C₁ to C₁₂ alkylphenyl group are preferable. In this context, the aryl group is an atomic group obtained by removing one hydrogen atom from an aromatic hydrocarbon. In this context, the aromatic hydrocarbon encompasses those having a condensed ring and those having two or more independent benzene or condensed rings bonded directly or via a group such as vinylene.
Specific examples of the C₁ to C₁₂ alkoxy include methoxy, ethoxy, propyloxy, isopropyloxy, butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy.
Specific examples of the C₁ to C₁₂ alkylphenyl group include a methylphenyl group, an ethylphenyl group, a dimethylphenyl group, a propylphenyl group, a mesityl group, a methylethylphenyl group, an isopropylphenyl group, a butylphenyl group, an isobutylphenyl group, a t-butylphenyl group, a pentylphenyl group, an isoamylphenyl group, a hexylphenyl group, a heptylphenyl group, an octylphenyl group, a nonylphenyl group, a decylphenyl group, and a dodecylphenyl group.

The alkoxy group may be linear, branched, or cyclic. The alkoxy group usually has approximately 1 to 10 carbon atoms, preferably 3 to 10 carbon atoms. Specific examples thereof include a methoxy group, an ethoxy group, a propyloxy group, an isopropyloxy group, a butoxy group, an isobutoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a lauryloxy group, a trifluoromethoxy group, a pentafluoroethoxy group, a perfluorobutoxy group, a perfluorohexyloxy group, a perfluorooctyloxy group, a methoxymethyloxy group, and a 2-methoxyethyloxy group. A pentyloxy group, a hexyloxy group, an octyloxy group, a 2-ethylhexyloxy group, a decyloxy group, and a 3,7-dimethyloctyloxy group are preferable.

The alkylthio group may be linear, branched, or cyclic. The alkylthio group usually has approximately 1 to 10 carbon atoms, preferably 3 to 10 carbon atoms. Specific examples thereof include a methylthio group, an ethylthio group, a propylthio group, an isopropylthio group, a butylthio group, an isobutylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, and a trifluoromethylthio group. A pentylthio group, a hexylthio group, an octylthio group, a 2-ethylhexylthio group, a decylthio group, and a 3,7-dimethyloctylthio group are preferable.

The aryloxy group usually has approximately 6 to 60 carbon atoms, preferably 7 to 48 carbon atoms. Specific examples thereof include a phenoxy group, a C₁ to C₁₂ alkoxyphenoxy group, a C₁ to C₁₂ alkylphenoxy group, a 1-naphthyloxy group, a 2-naphthyloxy group, and a pentafluorophenyloxy group. A C₁ to C₁₂ alkoxyphenoxy group and C₁ to C₁₂ alkylphenoxy group are preferable.
Specific examples of the C₁ to C₁₂ alkoxy include methoxy, ethoxy, propyloxy, isopropyloxy, butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy.
Specific examples of the C₁ to C₁₂ alkylphenoxy group include a methylphenoxy group, an ethylphenoxy group, a dimethylphenoxy group, a propylphenoxy group, a 1,3,5-trimethylphenoxy group, a methylethylphenoxy group, an isopropylphenoxy group, a butylphenoxy group, an isobutylphenoxy group, a t-butylphenoxy group, a pentylphenoxy group, an isoamylphenoxy group, a hexylphenoxy group, a heptylphenoxy group, an octylphenoxy group, a nonylphenoxy group, a decylphenoxy group, and a dodecylphenoxy group.

The arylthio group usually has approximately 6 to 60 carbon atoms, preferably 7 to 48 carbon atoms. Specific examples thereof include a phenylthio group, a C₁ to C₁₂ alkoxyphenylthio group, a C₁ to C₁₂ alkylphenylthio group, a 1-naphthylthio group, a 2-naphthylthio group, and a pentafluorophenylthio group. A C₁ to C₁₂ alkoxyphenylthio group and a C₁ to C₁₂ alkylphenylthio group are preferable.

The arylalkyl group usually has approximately 7 to 60 carbon atoms, preferably 7 to 48 carbon atoms. Specific examples thereof include a phenyl-C₁ to C₁₂ alkyl group, a C₁ to C₁₂ alkoxyphenyl-C₁ to C₁₂ alkyl group, a C₁ to C₁₂ alkylphenyl-C₁ to C₁₂ alkyl group, a 1-naphthyl-C₁ to C₁₂ alkyl group, and a 2-naphthyl-C₁ to C₁₂ alkyl group. A C₁ to C₁₂ alkoxyphenyl-C₁ to C₁₂ alkyl group and a C₁ to C₁₂ alkylphenyl-C₁ to C₁₂ alkyl group are preferable.

The arylalkyloxy usually has approximately 7 to 60 carbon atoms, preferably 7 to 48 carbon atoms. Specific examples thereof include a phenyl-C₁ to C₁₂ alkoxy group (e.g., a phenylmethoxy group, a phenylethoxy group, a phenylbutoxy group, a phenylpentyloxy group, a phenylhexyloxy group, a phenylheptyloxy group, and a phenyloctyloxy group), a C₁ to C₁₂ alkoxyphenyl-C₁ to C₁₂ alkoxy group, a C₁ to C₁₂ alkylphenyl-C₁ to C₁₂ alkoxy group, a 1-naphthyl-C₁ to C₁₂ alkoxy group, and a 2-naphthyl-C₁ to C₁₂ alkoxy group. A C₁ to C₁₂ alkoxyphenyl-C₁ to C₁₂ alkoxy group and a C₁ to C₁₂ alkylphenyl-C₁ to C₁₂ alkoxy group are preferable.

The arylalkylthio group usually has approximately 7 to 60 carbon atoms, preferably 7 to 48 carbon atoms. Specific examples thereof include a phenyl-C₁ to C₁₂ alkylthio group, a C₁ to C₁₂ alkoxyphenyl-C₁ to C₁₂ alkylthio group, a C₁ to C₁₂ alkylphenyl-C₁ to C₁₂ alkylthio group, a 1-naphthyl-C₁ to C₁₂ alkylthio group, and a 2-naphthyl-C₁ to C₁₂ alkylthio group. A C₁ to C₁₂ alkoxyphenyl-C₁ to C₁₂ alkylthio group and a C₁ to C₁₂ alkylphenyl-C₁ to C₁₂ alkylthio group are preferable.

The acyl group usually has approximately 2 to 20 carbon atoms, preferably 2 to 18 carbon atoms. Specific examples thereof include an acetyl group, a propionyl group, a butyryl group, an isobutyryl group, a pivaloyl group, a benzoyl group, a trifluoroacetyl group, and a pentafluorobenzoyl group.

The acyloxy group usually has approximately 2 to 20 carbon atoms, preferably 2 to 18 carbon atoms. Specific examples thereof include an acetoxy group, a propionyloxy group, a butyryloxy group, an isobutyryloxy group, a pivaloyloxy group, a benzoyloxy group, a trifluoroacetyloxy group, and a pentafluorobenzoyloxy group.

The monovalent heterocyclic group refers to an atomic group obtained by removing one hydrogen atom from a heterocyclic compound and usually has approximately 4 to 60 carbon atoms, preferably 4 to 20 carbon atoms. In this context, the number of carbon atoms of the heterocyclic group does not encompass the number of carbon atoms of a substituent. In this context, the heterocyclic compound refers to, of organic compounds having a cyclic structure, those in which the element constituting the ring contains not only carbon atoms but also heteroatoms such as oxygen, sulfur, nitrogen, phosphorus, and boron, within the ring. Specific example thereof include a thienyl group, a C₁ to C₁₂ alkylthienyl group, a pyrrolyl group, a furyl group, a pyridyl group, a C₁ to C₁₂ alkylpyridyl group, a piperidyl group, a quinolyl group, and an isoquinolyl group. A thienyl group, a C₁ to C₁₂ alkylthienyl group, a pyridyl group, and a C₁ to C₁₂ alkylpyridyl group are preferable.

The heteroaryloxy group usually has approximately 6 to 60 carbon atoms, preferably 7 to 48 carbon atoms. Specific examples thereof include a thienyloxy group, a C₁ to C₁₂ alkoxythienyloxy group, a C₁ to C₁₂ alkylthienyloxy group, a pyridyloxy group, a pyridyloxy group, and an isoquinolyloxy group. A C₁ to C₁₂ alkoxypyridyloxy group and a C₁ to C₁₂ alkylpyridyloxy group are preferable.
Specific examples of the C₁ to C₁₂ alkoxy include methoxy, ethoxy, propyloxy, isopropyloxy, butoxy, isobutoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, and lauryloxy.
Specific examples of the C₁ to C₁₂ alkylpyridyloxy group include a methylpyridyloxy group, an ethylpyridyloxy group, a dimethylpyridyloxy group, a propylpyridyloxy group, a 1,3,5-trimethylpyridyloxy group, a methylethylpyridyloxy group, an isopropylpyridyloxy group, a butylpyridyloxy group, an isobutylpyridyloxy group, a t-butylpyridyloxy group, a pentylpyridyloxy group, an isoamylpyridyloxy group, a hexylpyridyloxy group, a heptylpyridyloxy group, an octylpyridyloxy group, a nonylpyridyloxy group, a decylpyridyloxy group, and a dodecylpyridyloxy group.

The heteroarylthio group usually has approximately 6 to 60 carbon atoms, preferably 7 to 48 carbon atoms. Specific examples thereof include a pyridylthio group, a C₁ to C₁₂ alkoxypyridylthio group, a C₁ to C₁₂ alkylpyridylthio group, and an isoquinolylthio group. A C₁ to C₁₂ alkoxypyridylthio group and a C₁ to C₁₂ alkylpyridylthio group are preferable.

The arylalkenyl group usually has approximately 7 to 60 carbon atoms, preferably 7 to 48 carbon atoms. Specific examples thereof include a phenyl-C₂ to C₁₂ alkenyl group, a C₁ to C₁₂ alkoxyphenyl-C₂ to C₁₂ alkenyl group, a C₁ to C₁₂ alkylphenyl-C₂ to C₁₂ alkenyl group, a 1-naphthyl-C₂ to C₁₂ alkenyl group, and a 2-naphthyl-C₂ to C₁₂ alkenyl group. A C₁ to C₁₂ alkoxyphenyl-C₂ to C₁₂ alkenyl group and a C₂ to C₁₂ alkylphenyl-C₁ to C₁₂ alkenyl group are preferable.

The arylethynyl group usually has approximately 7 to 60 carbon atoms, preferably 7 to 48 carbon atoms. Specific examples thereof include a phenyl-C₂ to C₁₂ alkynyl group, a C₁ to C₁₂ alkoxyphenyl-C₂ to C₁₂ alkynyl group, a C₁ to C₁₂ alkylphenyl-C₂ to C₁₂ alkynyl group, a 1-naphthyl-C₂ to C₁₂ alkynyl group, and a 2-naphthyl-C₂ to C₁₂ alkynyl group. A C₁ to C₁₂ alkoxyphenyl-C₂ to C₁₂ alkynyl group and a C₁ to C₁₂ alkylphenyl-C₂ to C₁₂ alkynyl group are preferable.

It is preferred that the metal complex should have a structure represented by general formula (1A) below: 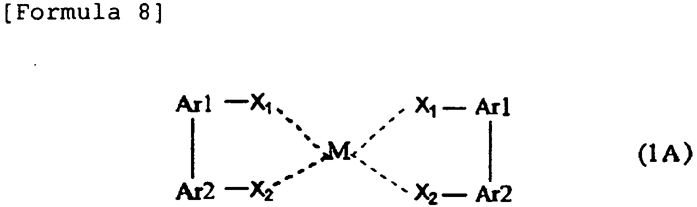 (in the formula, M, Ar1, Ar2, X₁, and X₂ are the same as above).

Hereinafter, specific examples of the metal complex represented by the general formula (1A) will be shown.

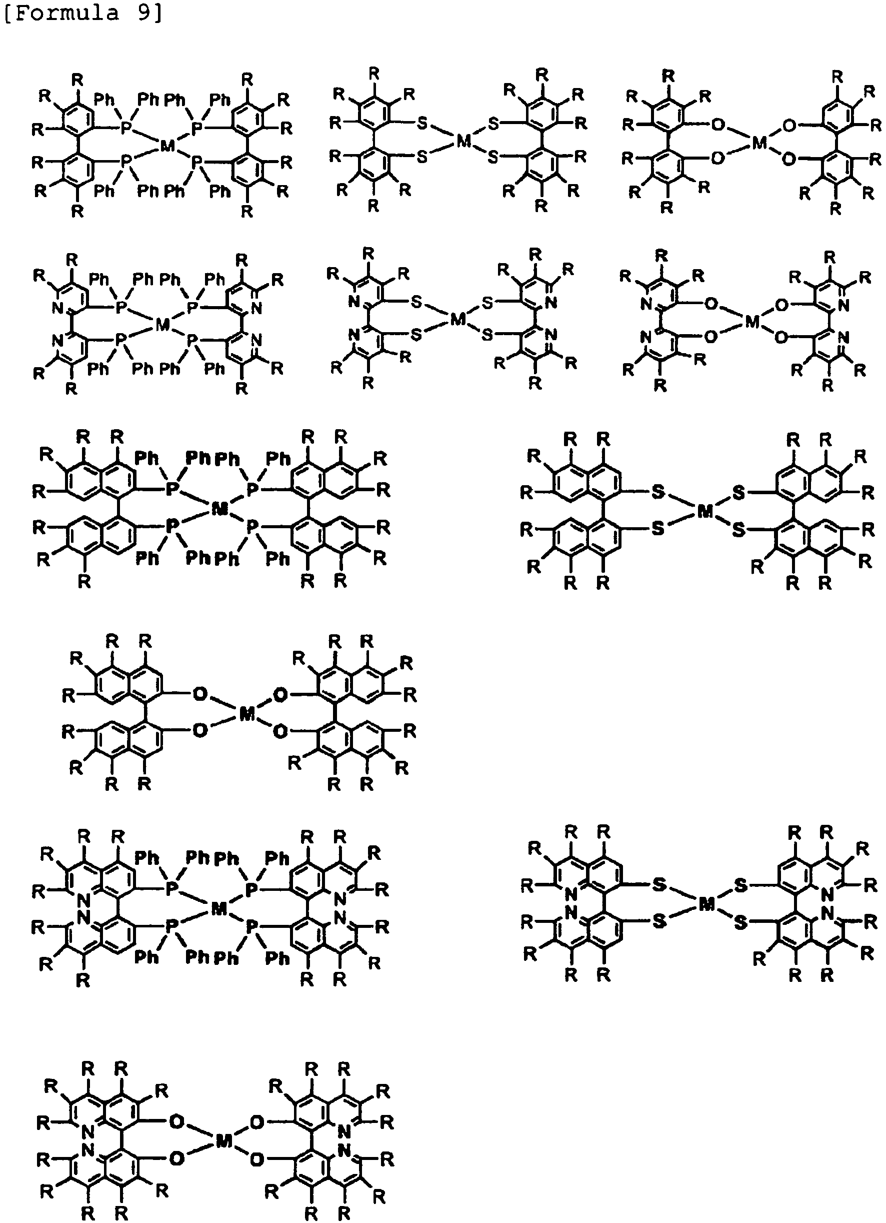

M in the formula represents a metal selected from a transition metal and a lanthanoid and is exemplified by Ru, Rh, Pd, W, Ir, Pt, and Au. R in the formula represents a substituent and is exemplified by a halogen atom, an alkyl group, an alkyloxy group, an alkylthio group, an aryl group, an aryloxy group, an arylthio group, an arylalkyl group, an arylalkyloxy group, an arylalkylthio group, an acyl group, an acyloxy group, an amide group, an acid imide group, an imine residue, a substituted amino group, a substituted silyl group, a substituted silyloxy group, a substituted silylthio group, a substituted silylamino group, a monovalent heterocyclic group, a heteroaryloxy group, a heteroarylthio group, an arylalkenyl group, and an arylethynyl group. Plural R groups may be identical or different.

The metal complex compound having the structure of the formula (1) may have a ligand having other structures or may have plural identical ligands. However, this metal complex compound is a neutral metal complex compound having at least two multidentate ligands including the formula (1). In this context, the multidentate ligand is a ligand coordinated at two or more positions to a metal.
The ligand having other structures is not particularly limited. Examples thereof include an alkyl group, phenylpyridine optionally substituted by a halogen atom, phenanthroline, phenylquinoline, and a bidentate ligand described in JP-A-2003-515897. These are examples of the multidentate ligand.

Light emission from the metal complex of the present invention is not particularly limited. It is preferred from the viewpoint of obtaining high efficiency that light emission from an MLCT (Metal to Ligand Charge Transfer) excited state is involved.

Next, a method for synthesizing the metal complex of the present invention will be described.
The metal complex used in the present invention can be synthesized according to a method described in, for example, Inorganic Chemistry, vol. 43, 663-673 (2004) or Journal of the Chemistry Society Chemical Communications, p. 2273-2274 (1995).

For synthesis operation, a solvent is added into a flask. This solvent is stirred, while degasification is performed by bubbling or the like using inactive gas, for example, nitrogen or argon gas. Then, a complex and a ligand are added thereto. If necessary, a reducing agent is added thereto. The mixture is stirred, while the stirring is continued until ligand substitution occurs under an inactive gas atmosphere. The end point of the reaction can be determined by TLC monitor or high-performance liquid chromatography when reduction in the amounts of the raw materials stops or either of the raw materials disappears.
The collection of the substance of interest from the reaction mixture solution as well as purification conditions thereof differs depending on a complex. A usual complex purification approach, for example, recrystallization, is used.
The identification and analysis of the compound can be conducted by CHN elemental analysis and NMR.

The material of the present invention is characterized in that the material is a composition containing a neutral metal complex and a charge-transporting material which is conjugated polymer, the neutral metal complex having a partial structure represented by the general formula (1) and at least two multidentate ligands, or is a polymer intramolecularly containing a residue of the metal complex and a residue of the charge-transporting material.
Preferably, the material of the present invention is a composition containing the metal complex and the charge-transporting material.

The charge-transporting material contained in the material of the present invention may be a low-molecular-weight organic compound or may be a polymer. Examples thereof include hole-transporting materials and electron-transporting materials.
Examples of the hole-transporting materials include those heretofore used as hole-transporting materials in organic EL devices, such as aromatic amine, carbazole derivatives, and polyparaphenylene derivatives.
Likewise, examples of the electron-transporting materials include those heretofore used as electron-transporting materials in organic EL devices, such as oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, and metal complexes of 8-hydroxyquinoline or derivatives thereof.
The low-molecular-weight organic compound as the charge-transporting material represents host compounds used in low-molecular-weight organic EL devices and charge-injecting/transporting compounds. Specific examples thereof can include compounds described in, for example, "Organic EL Display" (S. Tokito, C. Adachi, and H. Murata, Ohmsha), p. 107, Monthly Display, vol. 9, No. 9, 2003, p. 26-30, JP-A-2004-244400, and JP-A-2004-277377.

Moreover, a polymer can also be used as the charge-transporting material. Examples of the polymer include unconjugated polymers and conjugated polymers.
Examples of the unconjugated polymers include polyvinylcarbazole.
Examples of the conjugated polymers include polymers containing an aromatic ring in the principal chain and containing, for example, an optionally substituted phenylene group, fluorene, dibenzothiophene, dibenzofuran, or dibenzosilol as repeating units in the principal chain, and copolymers with these units. Further specific examples thereof include a polymer compound characterized by having an optionally substituted benzene ring and/or a partial structure represented by the general formula (2) below. Specific examples thereof include polymers described in, for example, JP-A-2003-231741, JP-A-2004-059899, JP-A-2004-002654, JP-A-2004-292546, US5708130, WO9954385, W00046321, WO02077060, "Organic EL Display" (S. Tokito, C. Adachi, and H. Murata, Ohmsha), p. 111, and Monthly Display, vol. 9, No. 9, 2002, p. 47-51. 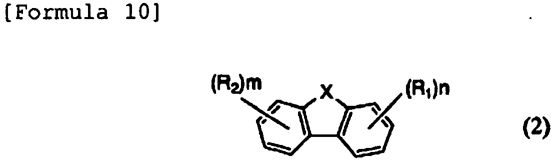 In the formula, X represents N, O, S, Se, B, Si, P, C, C-C, O-C, S-C, N-C, Si-C, Si-Si, C=C, or Si=C and is optionally substituted depending on a valence. N, O, S, Se, B, Si, P, and C are preferable. Preferably, -X- represents -O-, -S-, -Se-, -B(R₃₁)-, -Si(R₃₂)(R₃₃)-, -P(R₃₄)-, -PR₃₆(=O)-, -C(R₃₇)(R₃₈)*-*, -C(R₅₁)(R₅₂)-C(R₅₃)(R₅₄)-. -O-C(R₅₅)(R₅₆)-, -S-C(R₅₇)(R₅₈)-, -N-C(R₅₉) (R₆₀) -Si(R₆₁)(R₆₂)-C(R₆₃)(R₆₄)-, -Si(R₆₅) (R₆₆)-Si(R₆₇)(R₆₈)-, -C(R₆₉)=C(R₇₀)-, -N(R₃₅)-, -N=C (R₇₁) -, or -Si(R₇₂)=C(R₇₃)-, wherein R₃₁ to R₃₈ and R₅₁ to R₇₃ independently represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, or a halogen atom. R₁ and R₂ independently represent a hydrogen atom, a halogen atom, an alkyl group, an alkoxy group, an aryl group, or a bond to other atoms. m and n independently represent an integer of 0 to 4.
In this context, specific examples of the alkyl group, the alkoxy group, the alkylthio group, the aryl group, the aryloxy group, the arylthio group, the arylalkyl group, the arylalkoxy group, the arylalkylthio group, the arylalkenyl group, the arylalkynyl group, the monovalent heterocyclic group, or the halogen atom can include the examples described above.

Examples of the charge-transporting material represented by the general formula (2) will be shown below: 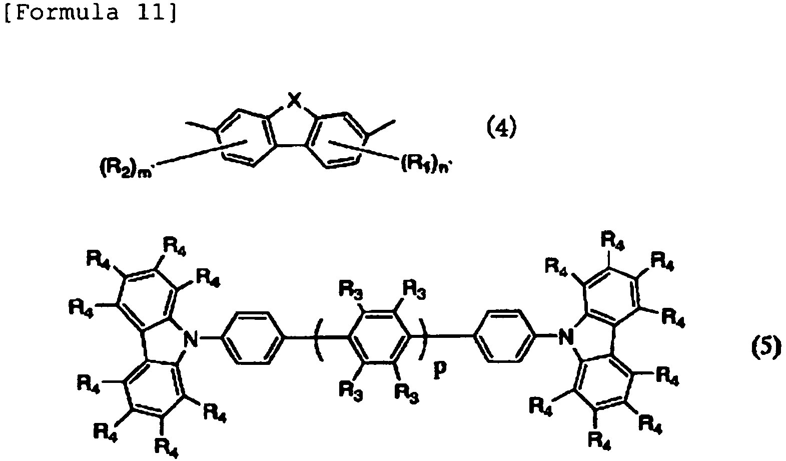 (the formula (4) represents repeating units having bonds at the positions 2 and 7. In the formula (4), X represents N, O, S, Se, B, Si, P, or C and is optionally substituted depending on a valence; R₁ and R₂ independently represent a hydrogen atom, a halogen atom, an alkyl group, an alkoxy group, or aryl group; and m' and n' independently represent an integer of 0 to 3. In the formula (5), R₃ and R₄ independently represent an alkyl group optionally substituted by fluorine, an alkoxy group, an aryl group, or a halogen atom; and p is 0 or 1).
It is preferred that in the formula (4), X should be O, S, -N(R₃₅)-, or C(R₃₇)(R₃₈). The R₃₅, R₃₇, and R₃₈ moieties independently represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, or a halogen atom.

When the charge-transporting material is a conjugated polymer, the charge-transporting material may be a copolymer of the unit of the formula (4) with other repeating units. Examples of the other repeating units include formulas (6) and (7) below:

-Ar₁- (6)

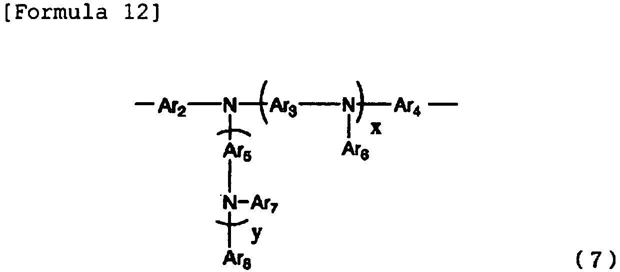

(in the formula, Ar₁, Ar₂, Ar₃, Ar₄, and Ar₅ independently represent an arylene group or a divalent heterocyclic group. Ar₅, Ar₆, Ar₇, and Ar₈ independently represent an aryl group or a monovalent heterocyclic group. Ar₁, Ar₆, Ar₇, and Ar₈ are optionally substituted. x and y independently represent 0 or 1 and establish the relationship of 0≤x+y<1).

In this context, the arylene group is an atomic group obtained by removing two hydrogen atoms from an aromatic hydrocarbon and usually has approximately 6 to 60 carbon atoms, preferably 6 to 20 carbon atoms. In this context, the aromatic hydrocarbon encompasses those having a condensed ring and those having two or more independent benzene or condensed rings bonded directly or via a group such as vinylene. Examples thereof will be shown below:

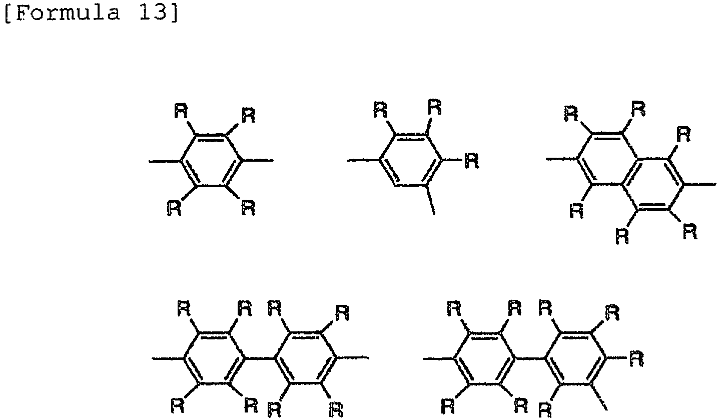

The charge-transporting material may be a conjugated polymer composition containing the material described above.

For the material of the present invention, the material itself may be a conjugated polymer intramolecularly containing a residue of a neutral metal complex and a residue of a charge-transporting material, the neutral metal complex having a partial structure represented by the general formula (1) and at least two multidentate ligands. In this case, the polymer itself has functions as the metal complex and the charge-transporting material.

Alternatively, for the material of the present invention, the charge-transporting material may be a conjugated polymer intramolecularly containing a structure of a metal complex having a partial structure represented by the general formula (1). In this case as well, the polymer itself has functions as the charge-transporting material and the metal complex, while the material of the present invention may contain the metal complex as an additional component.

For the material of the present invention, when the material itself is a polymer intramolecularly containing a structure of a metal complex having a partial structure represented by the general formula (1) or when the charge-transporting material is a conjugated polymer intramolecularly containing a structure of a metal complex having a partial structure represented by the general formula (1), as described above, examples thereof include:
a polymer having a structure (B) of a metal complex having a partial structure represented by the general formula (1) in the principal chain of a polymer (A);
a polymer having a structure (B) of a metal complex having a partial structure represented by the general formula (1) at the end of a polymer (A); and
a polymer having a structure (B) of a metal complex having a partial structure represented by the general formula (1) in the side chain of a polymer (A).

The polymer structure having a structure (B) of a metal complex having a partial structure represented by the general formula (1) in the side chain of a polymer (A) is represented by, for example, the formula below: 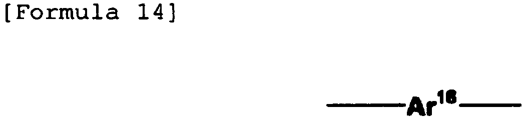 (in the formula, Ar¹⁸ represents a divalent aromatic group or represents a divalent heterocyclic group having one or more atoms selected from the group consisting of an oxygen atom, a silicon atom, a germanium atom, a tin atom, a phosphorus atom, a boron atom, a sulfur atom, a selenium atom, and a tellurium atom. The Ar¹⁸ has one to four groups inclusive represented by -L-X-, wherein X represents a monovalent group containing the structure of the metal complex having a partial structure represented by the general formula (1), and L represents a single bond, -O-, -S-, -CO-, -CO₂-, -SO-, -SO₂-, -SiR⁶⁸R⁶⁹-, NR⁷⁰-, -BR⁷¹-, -PR⁷²-, -P(=O)(R⁷³)-, an optionally substituted alkylene group, an optionally substituted alkenylene group, an optionally substituted alkynylene group, an optionally substituted arylene group, or an optionally substituted divalent heterocyclic group. When the alkylene group, the alkenylene group, or the alkynylene group contains a -CH₂- group, each of one or more -CH₂- groups contained in the alkylene group, the alkenylene group, or the alkynylene group is optionally substituted by a group selected from the group consisting of -O-, -S-, -CO-, -CO₂-, -SO-, -SO₂-, -SiR⁷⁴R⁷⁵-, NR⁷⁶-, -BR⁷⁷-, -PR⁷⁸-, and -P(=O)(R⁷⁹)-. R⁶⁸, R⁶⁹, R⁷⁰, R⁷¹, R⁷²_{,} R⁷³, R⁷⁴. R⁷⁵, R⁷⁶, R⁷⁷, R⁷⁸, and R⁷⁹ independently represent a group selected from the group consisting of a hydrogen atom, an alkyl group, an aryl group, a monovalent heterocyclic group, and a cyano group. Ar¹⁸ optionally has, in addition to the group represented by -L-X, an additional substituent selected from the group consisting of an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, an amino group, a substituted amino group, a silyl group, a substituted silyl group, a halogen atom, an acyl group, an acyloxy group, an imine residue, an amide group, an acid imide group, a monovalent heterocyclic group, a carboxyl group, a substituted carboxyl group, and a cyano group. When Ar¹⁸ has plural substituents, these substituents may be identical or different from each other).
In this context, examples of the divalent aromatic group include phenylene, pyridinylene, pyrimidylene, naphthylene, and the ring represented by the general formula (2).

The polymer structure having a structure (B) of a metal complex having a partial structure represented by the general formula (1) in the principal chain of a polymer (A) is represented by, for example, formula below: 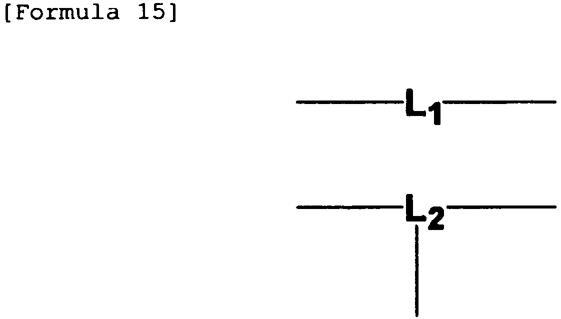 (in the formula, L₁ and L₂ represent a structure of a phosphorescent light-emitting molecule. A divalent or trivalent bonding group in the formula represents the structure of the metal complex having a partial structure represented by the general formula (1), which is bonded to repeating units forming the principal chain).

The polymer structure having a structure (B) of a metal complex having a partial structure represented by the general formula (1) at the end of a polymer (A) is represented by, for example, the formula below: 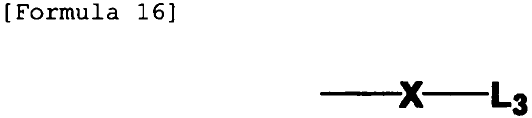 (in the formula, L₃ represents a monovalent group containing the structure (B) of the metal complex having a partial structure represented by the general formula (1), and the monovalent bonding group has this structure (B) and is bonded to X; and X represents a single bond, an optionally substituted alkenylene group, an optionally substituted alkynylene group, an optionally substituted arylene group, or an optionally substituted divalent heterocyclic group).

The polymer having a structure (B) of a metal complex having a partial structure represented by the general formula (1) in the side chain, in the principal chain, or at the end can be produced by the method described above using, for example, a monomer having the structure (B) of the metal complex as one of raw materials.

The polymer used in the material of the present invention has a number-average molecular weight of preferably 10³ to 10⁸, more preferably 10⁴ to 10⁶, in terms of polystyrene. The polymer has a weight-average molecular weight of 10³ to 10⁸, preferably 5×10⁴ to 5×10⁶, in terms of polystyrene.
The polymer intramolecularly containing the structure of the metal complex is also exemplified by the polymers described as the polymer used in the material of the present invention, for example, the polymer containing repeating units of the general formula (4).

The amount of the metal complex structure in the material of the present invention differs depending on the types of organic compounds used in combination or properties to be optimized. Therefore, the amount of the metal complex structure is not particularly limited and is usually 0.01 to 80 parts by weight, preferably 0.1 to 60 parts by weight, with respect to 100 parts by weight of organic compounds other than the metal complex structure. Moreover, the material of the present invention may contain two or more metal complexes.

Moreover, any material of the present invention may contain a light-emitting material, in addition to the charge-transporting material. Light-emitting materials known in the art can be used. Examples of low-molecular-weight compounds that can be used include naphthalene derivatives, anthracene or derivatives thereof, perylene or derivatives thereof, polymethine-type, xanthene-type, coumarin-type, and cyanine-type dyes, metal complexes of 8-hydroxyquinoline or derivatives thereof, aromatic amine, tetraphenylcyclopentadiene or derivatives thereof, and tetraphenylbutadiene or derivatives thereof.

### <Liquid composition>

The composition and the polymer compound of the present invention are particularly useful as a liquid composition in the production of a light-emitting device (e.g., a polymer light-emitting device) or an organic transistor. The liquid composition comprises the composition of the present invention optionally containing a solvent or comprises the polymer compound of the present invention and a solvent. In the present specification, the "liquid composition" means those in a liquid state during device production and typically means those in a liquid state at 25°C at normal pressure (i.e., 1 atm). Moreover, the liquid composition is generally called ink, an ink composition, a solution, and so on, in some cases.

When this liquid composition (e.g., the composition in a solution state) is used to form a film in the production of a polymer light-emitting device, a procedure to be done is just the removal of the solvent by drying after the application of the liquid composition. Moreover, when the charge-transporting material or the light-emitting material is mixed therewith, the same approach can be utilized. Therefore, this approach is very useful in terms of production. In this context, the drying may be performed in a heated state to approximately 50 to 150°C or may be performed under reduced pressure on the order of 10⁻³ Pa.

Examples of film formation methods using the liquid composition that can be used include coating methods such as spin coating, casting, micro-gravure coating, gravure coating, bar coating, roll coating, wire bar coating, dip coating, spray coating, screen printing, flexographic printing, offset printing, and ink jet printing methods.

The proportion of the solvent in the liquid composition is usually 1% by weight to 99.9% by weight, preferably 60% by weight to 99.9% by weight, more preferably 90% by weight to 99.8% by weight, with respect to the whole weight of the liquid composition. The viscosity of the liquid composition differs depending on a printing method and, preferably, ranges from 0.5 to 500 mPa·s at 25°C. When the liquid composition is used through a discharge apparatus in an ink jet printing method or the like, it is preferred for preventing clogging during discharge or the flying curve of the discharged liquid droplets that the viscosity should range from 0.5 to 20 mPa·s at 25°C. Moreover, the total sum of the weights of the polymer and the compound that exhibits phosphorescent light emission, or the weight of the polymer compound is usually 20% by weight to 100% by weight, preferably 40% by weight to 100% by weight, with respect to the total weight of all the components in the liquid composition except for the solvent.

Solvents that permit for the dissolution or dispersion of the components in the liquid composition except for the solvent are preferable as the solvent contained in the liquid composition. Examples of the solvent include: chlorine-type solvents such as chloroform, methylene chloride, 1,2-dichloroethane, 1,1,2-trichloroethane, chlorobenzene, and o-dichlorobenzene; ether-type solvents such as tetrahydrofuran and dioxane; aromatic hydrocarbon-type solvents such as toluene, xylene, trimethylbenzene, and mesitylene; aliphatic hydrocarbon-type solvents such as cyclohexane, methylcyclohexane, n-pentane, n-hexane, n-heptane, n-octane, n-nonane, and n-decane; ketone-type solvents such as acetone, methyl ethyl ketone, and cyclohexanone; ester-type solvents such as ethyl acetate, butyl acetate, methyl benzoate, and ethyl cellosolve acetate; polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, and 1,2-hexanediol; alcohol-type solvents such as methanol, ethanol, propanol, isopropanol, and cyclohexanol; sulfoxide-type solvents such as dimethyl sulfoxide; and amide-type solvents such as N-methyl-2-pyrrolidone and N,N-dimethylformamide. Moreover, these solvents may be used alone or in combination of two or more of them. It is preferred from the viewpoint of viscosity, film-forming properties, and so on that the liquid composition should contain, of the solvents, one or more organic solvents that have a structure containing at least one or more benzene rings and have a melting point of 0°C or lower and a boiling point of 100°C or higher.

Aromatic hydrocarbon-type solvents, aliphatic hydrocarbon-type solvents, ester-type solvents, and ketone-type solvent are preferable as the type of the solvent from the viewpoint of the solubility of the components in the liquid composition except for the solvent in the organic solvent, uniform film formation, viscosity characteristics, and so on. Toluene, xylene, ethylbenzene, diethylbenzene, trimethylbenzene, mesitylene, n-propylbenzene, isopropylbenzene, n-butylbenzene, isobutylbenzene, s-butylbenzene, anisole, ethoxybenzene, 1-methylnaphthalene, cyclohexane, cyclohexanone, cyclohexylbenzene, bicyclohexyl, cyclohexenyl cyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone, dicyclohexyl ketone are preferable. It is more preferred that the liquid composition should contain at least one of xylene, anisole, mesitylene, cyclohexylbenzene, bicyclohexyl, and methyl benzoate.

It is preferred from the viewpoint of film-forming properties, device characteristics, and so on that the liquid composition should contain two or more solvents, more preferably two to three solvents, even more preferably two solvents.

When the liquid composition contains two solvents, one of these solvents may be in a solid state at 25°C. It is preferred from the viewpoint of film-forming properties that one of the solvents should have a boiling point of 180°C or higher, and the other solvent should have a boiling point of 180°C or lower. It is more preferred that one of the solvents should have a boiling point of 200°C or higher, and the other solvent should have a boiling point of 180°C or lower. Moreover, it is preferred from the viewpoint of viscosity that 0.2% by weight or more of the components in the liquid composition except for the solvents should be dissolved in one of the two solvents at 60°C and in the other solvent at 25°C.

When the liquid composition contains three solvents, one or two of these solvents may be in a solid state at 25°C. It is preferred from the viewpoint of film-forming properties that at least one of these three solvents should have a boiling point of 180°C or higher, and at least one of the remaining solvents should have a boiling point of 180°C or lower. It is more preferred that at least one of these three solvents should have a boiling point of 200°C to 300°C inclusive, and at least one of the remaining solvents should have a boiling point of 180°C or lower. Moreover, it is preferred from the viewpoint of viscosity that 0.2% by weight or more of the components in the liquid composition except for the solvents should be dissolved in two of these three solvents at 60°C and in the remaining one solvent at 25°C.

When the liquid composition contains two or more solvents, it is preferred from the viewpoint of viscosity and film-forming properties that the amount of the solvent having the highest boiling point should be 40 to 90% by weight, more preferably 50 to 90% by weight, even more preferably 65 to 85% by weight, with respect to the total weight of all the solvents contained in the liquid composition.

A combination of anisole and bicyclohexyl, a combination of anisole and cyclohexylbenzene, a combination of xylene and bicyclohexyl, a combination of xylene and cyclohexylbenzene, and a combination of mesitylene and methyl benzoate are preferable as the solvents contained in the liquid composition from the viewpoint of viscosity and film-forming properties.

It is preferred from the viewpoint of the solubility of the components contained in the liquid composition except for the solvents in the solvents that the solubility parameter of the solvents and the solubility parameter of the polymer contained in the composition of the present invention or the polymer compound of the present invention differ by 10 or less, more preferably 7 or less. These solubility parameters can be determined by a method described in "Solvent Handbook (published by Kodansha, 1976)".

Subsequently, a thin film of the present invention will be described. This thin film is obtained using the composition, the liquid composition, or the polymer compound (hereinafter, the composition, the liquid composition, and the polymer compound are collectively referred to as the "composition, etc."). Examples of the type of the thin film include a light-emitting thin film, a conductive thin film, and an organic semiconductor thin film.

It is preferred from the viewpoint of the luminance or light-emitting voltage of a device that the light-emitting thin film should have a high emission quantum yield.

It is preferred that the conductive thin film should have a surface resistance of 1 KΩ/□ or smaller. The thin film can be doped with Lewis acid, an ionic compound, or the like to thereby enhance electric conductivity. The surface resistance is more preferably 100 Ω/□ or smaller, even more preferably 10 Ω/□ or smaller.

It is preferred that the organic semiconductor thin film should have an electron mobility or a hole mobility (whichever is lager) of 10⁻⁵ cm²/V/second or larger, more preferably 10⁻³ cm²/V/second or larger, even more preferably 10⁻¹ cm²/V/second or larger. Moreover, the organic semiconductor thin film can be used to produce an organic transistor. Specifically, the organic semiconductor thin film is formed onto an Si substrate comprising an insulating film (which is made of SiO₂ or the like) and a gate electrode formed thereon. Source and drain electrodes can further be formed thereon using Au or the like to prepare an organic transistor.

The present invention also relates to a photoelectric device characterized by comprising the material of the present invention.
The photoelectric device of the present invention is characterized in that the photoelectric device has a layer containing the metal complex of the present invention or the material of the present invention between electrodes comprising an anode and a cathode. For example, the photoelectric device of the present invention can be used as a light-emitting device, a switching device, or a photoelectric conversion device. When the device is a light-emitting device, it is preferred that the layer containing the metal complex of the present invention should be a light-emitting layer.
Moreover, the photoelectric device of the present invention may further comprise a charge-transporting layer or a charge-blocking layer between the electrodes comprising an anode and a cathode. The charge-transporting layer means a hole-transporting layer or an electron-transporting layer. The charge-blocking layer means a hole-blocking layer or an electron-blocking layer. Examples of such photoelectric device include: a light-emitting device provided with an electron-transporting layer or a hole-blocking layer between a cathode and a photoelectric layer; a light-emitting device provided with a hole-transporting layer or an electron-blocking layer between an anode and a photoelectric layer; and a light-emitting device provided with an electron-transporting layer or a hole-blocking layer between a cathode and photoelectric layer and with a hole-transporting layer or an electron-blocking layer between an anode and the photoelectric layer. In this context, the electron-transporting layer and the hole-blocking layer have the same functions, as described in "All About Organic EL", p. 162 (J. Kido, Nippon Jitsugyo Publishing). For example, the same materials can be used to constitute the electron-transporting layer and the hole-blocking layer. Depending on the characteristics of the materials, the functions of either the electron-transporting layer or the hole-blocking layer may be reflected more strongly. The same holds true for the hole-transporting layer and the electron-blocking layer. Examples of the light-emitting device of the present invention include device structures described in, for example, Patent Document (Journal of the SID 11/1, 161-166, 2003).
Alternative examples thereof include: a light-emitting device provided, between at least one of the electrodes and a photoelectric layer, with a layer containing a conductive polymer adjacent to the electrode; and a light-emitting device provided, between at least one of the electrodes and a photoelectric layer, with a buffer layer of 2 nm or smaller in average film thickness adjacent to the electrode.

Specific examples thereof include structures a) to d) below:
a) anode/photoelectric layer/cathode
b) anode/hole-transporting layer/photoelectric layer/cathode
c) anode/photoelectric layer/electron-transporting layer/cathode
d) anode/hole-transporting layer/photoelectric layer/electron-transporting layer/cathode (in this context, the mark / means that the layers are stacked adjacent to each other; the same holds true for the descriptions below).
In this context, the photoelectric layer is a layer having photoelectric functions, that is, a thin film having light-emitting properties, conductivity, and photoelectric conversion functions. The hole-transporting layer is a layer having the function of transporting holes. The electron-transporting layer is a layer having the function of transporting electrons. The electron-transporting layer and the hole-transporting layer are collectively referred to as a charge-transporting layer.
The photoelectric layer, the hole-transporting layer, and the electron-transporting layer may independently be used as two or more layer.
Moreover, of the charge-transporting layers provided adjacent to the electrode, particularly those having the function of improving charge-injecting efficiency from the electrode and the effect of lowering the drive voltage of the device are generally called charge-injecting layers (hole-injecting layers or electron-injecting layers) in some cases.

Moreover, for improving adhesion to the electrode or improving charge injection from the electrode, the charge-injecting layer or an insulating layer of 2 nm or smaller in film thickness may be provided adjacent to the electrode. Alternatively, for improving the adhesion of the interfaces or preventing the admixture between the layers, etc, a thin buffer layer may be inserted into the interface of the charge-transporting layer or the photoelectric layer.
Furthermore, for transporting electrons and entrapping holes, the hole-blocking layer may be inserted into the interface of the photoelectric layer.
The order or number of the layers to be stacked and the thickness of each layer can be determined appropriately in consideration of light-emitting efficiency and device lifetime.

In the present invention, examples of the light-emitting device provided with the charge-injecting layer (electron-injecting layer or hole-injecting layer) include a light-emitting device provided with a charge-injecting layer adjacent to a cathode and a light-emitting device provided with a charge-injecting layer adjacent to an anode.
Specific examples thereof include structures e) to p) below:
e) anode/charge-injecting layer/photoelectric layer/cathode
f) anode/photoelectric layer/charge-injecting layer/cathode
g) anode/charge-injecting layer/photoelectric layer/charge-injecting layer/cathode
h) anode/charge-injecting layer/hole-transporting layer/photoelectric layer/cathode
i) anode/hole-transporting layer/photoelectric layer/charge-injecting layer/cathode
j) anode/charge-injecting layer/hole-transporting layer/photoelectric layer/charge-injecting layer/cathode
k) anode/charge-injecting layer/photoelectric layer/charge-transporting layer/cathode
l) anode/photoelectric layer/electron-transporting layer/charge-injecting layer/cathode
m) anode/charge-injecting layer/photoelectric layer/electron-transporting layer/charge-injecting layer/cathode
n) anode/charge-injecting layer/hole-transporting layer/photoelectric layer/charge-transporting layer/cathode
o) anode/hole-transporting layer/photoelectric layer/electron-transporting layer/charge-injecting layer/cathode
p) anode/charge-injecting layer/hole-transporting layer/photoelectric layer/electron-transporting layer/charge-injecting layer/cathode.

Specific examples of the charge-injecting layer include: a layer containing a conductive polymer; a layer that is provided between an anode and a hole-transporting layer and comprises a material having an ionization potential value intermediate between those of an anode material and a hole-transporting material contained in the hole-transporting layer; and a layer that is provided between a cathode and an electron-transporting layer and comprises a material having an electron affinity value intermediate between those of a cathode material and an electron-transporting material contained in the electron-transporting layer.

When the charge-injecting layer is a layer containing a conductive polymer, it is preferred that the conductive polymer should have electric conductivity of 10⁻⁵ S/cm to 10³ S/cm inclusive. For reducing leak electric currents between light-emitting pixels, it is more preferred that the conductive polymer should have electric conductivity of 10⁻⁵ S/cm to 10² S/cm inclusive, even more preferably 10⁻⁵ S/cm to 10¹ S/cm inclusive.
To keep the electric conductivity of the conductive polymer at 10⁻⁵ S/cm to 10³ S/cm inclusive, the conductive polymer is usually doped with an appropriate amount of ions.
The types of the ions for doping are anions for the hole-injecting layer and are cations for the electron-injecting layer. Examples of the anions include polystyrene sulfonic acid ions, alkylbenzene sulfonic acid ions, and camphorsulfonic acid ions. Examples of the cations include lithium ions, sodium ions, potassium ions, and tetrabutylammonium ions.

The film thickness of the charge-injecting layer is, for example, 1 nm to 100 nm, preferably 2 nm to 50 nm.
Materials used in the charge-injecting layer may be selected appropriately in connection with materials for the electrode or the adjacent layer and is exemplified by polyaniline and derivatives thereof, polyaminophene and derivatives thereof, polypyrrole and derivatives thereof, polyphenylenevinylene and derivatives thereof, polythienylenevinylene and derivatives thereof, polyquinoline and derivatives thereof, polyquinoxaline and derivatives thereof, conductive polymers such as polymers containing an aromatic amine structure in the principal chain or the side chain, metal phthalocyanine (copper phthalocyanine), and carbon.

The insulating layer of 2 nm or smaller in film thickness has the function of facilitating charge injection. Examples of materials for the insulating layer include metal fluorides, metal oxides, and organic insulating materials. Examples of the light-emitting device provided with the insulating layer of 2 nm or smaller in film thickness include a light-emitting device provided with an insulating layer of 2 nm or smaller in film thickness adjacent to a cathode and a light-emitting device provided with an insulating layer of 2 nm or smaller in film thickness adjacent to an anode.
Specific examples thereof include structures q) to ab) below:
q) anode/insulating layer of 2 nm or smaller in film thickness/photoelectric layer/cathode
r) anode/photoelectric layer/insulating layer of 2 nm or smaller in film thickness/cathode
s) anode/insulating layer of 2 nm or smaller in film thickness/photoelectric layer/insulating layer of 2 nm or smaller in film thickness/cathode
t) anode/insulating layer of 2 nm or smaller in film thickness/hole-transporting layer/photoelectric layer/cathode
u) anode/hole-transporting layer/photoelectric layer/insulating layer of 2 nm or smaller in film thickness/cathode
v) anode/insulating layer of 2 nm or smaller in film thickness/hole-transporting layer/photoelectric layer/insulating layer of 2 nm or smaller in film thickness/cathode
w) anode/insulating layer of 2 nm or smaller in film thickness/photoelectric layer/electron-transporting layer/cathode
x) anode/photoelectric layer/electron-transporting layer/insulating layer of 2 nm or smaller in film thickness/cathode
y) anode/insulating layer of 2 nm or smaller in film thickness/photoelectric layer/electron-transporting layer/insulating layer of 2 nm or smaller in film thickness/cathode
z) anode/insulating layer of 2 nm or smaller in film thickness/hole-transporting layer/photoelectric layer/electron-transporting layer/cathode
aa) anode/hole-transporting layer/photoelectric layer/electron-transporting layer/insulating layer of 2 nm or smaller in film thickness/cathode
ab) anode/insulating layer of 2 nm or smaller in film thickness/hole-transporting layer/photoelectric layer/electron-transporting layer/insulating layer of 2 nm or smaller in film thickness/cathode.

The hole-blocking layer has the function of transporting electrons and the function of entrapping holes transported from the anode. The hole-blocking layer is provided at the interface on the cathode side of the photoelectric layer and made of a material having an ionization potential larger than that of the photoelectric layer, for example, bathocuproin or metal complexes of 8-hydroxyquinoline or derivatives thereof.
The film thickness of the hole-blocking layer is, for example, 1 nm to 100 nm, preferably 2 nm to 50 nm.
Specific examples thereof include structures ac) to an) below:
ac) anode/charge-injecting layer/photoelectric layer/hole-blocking layer/cathode
ad) anode/photoelectric layer/hole-blocking layer/charge-injecting layer/cathode
ae) anode/charge-injecting layer/photoelectric layer/hole-blocking layer/charge-injecting layer/cathode
af) anode/charge-injecting layer/hole-transporting layer/photoelectric layer/hole-blocking layer/cathode
ag) anode/hole-transporting layer/photoelectric layer/hole-blocking layer/charge-injecting layer/cathode
ah) anode/charge-injecting layer/hole-transporting layer/photoelectric layer/hole-blocking layer/charge-injecting layer/cathode
ai) anode/charge-injecting layer/photoelectric layer/hole-blocking layer/charge-transporting layer/cathode
aj) anode/photoelectric layer/hole-blocking layer/electron-transporting layer/charge-injecting layer/cathode
ak) anode/charge-injecting layer/photoelectric layer/hole-blocking layer/electron-transporting layer/charge-injecting layer/cathode
al) anode/charge-injecting layer/hole-transporting layer/photoelectric layer/hole-blocking layer/charge-transporting layer/cathode
am) anode/hole-transporting layer/photoelectric layer/hole-blocking layer/electron-transporting layer/charge-injecting layer/cathode
an) anode/charge-injecting layer/hole-transporting layer/photoelectric layer/hole-blocking layer/electron-transporting layer/charge-injecting layer/cathode.

When the photoelectric material including the charge-transporting material is used to form a film from a solution in the production of the photoelectric device of the present invention, a procedure to be done is just the removal of the solvent by drying after the application of this solution. Moreover, when the charge-transporting material or the light-emitting material is mixed therewith, the same approach can be utilized. Therefore, this approach is very useful in terms of production. Examples of film formation methods from the solution that can be used include coating methods such as spin coating, casting, micro-gravure coating, gravure coating, bar coating, roll coating, wire bar coating, dip coating, spray coating, screen printing, flexographic printing, offset printing, and ink jet printing methods. Alternatively, when the light-emitting material including the charge-transporting material is a relatively low molecule, a film as the photoelectric layer may be formed using a vacuum deposition method.

In the light-emitting device as one aspect of the photoelectric device of the present invention, the photoelectric layer (i.e., the light-emitting layer) may be mixed for use with a light-emitting material other than the photoelectric material of the present invention. Moreover, in the photoelectric device of the present invention, a light-emitting layer containing a light-emitting material other than the light-emitting material of the present invention may be stacked with the photoelectric layer containing the light-emitting material of the present invention.

Light-emitting materials known in the art can be used. Examples of low-molecular-weight compounds that can be used include naphthalene derivatives, anthracene or derivatives thereof, perylene or derivatives thereof, polymethine-type, xanthene-type, coumarin-type, and cyanine-type dyes, metal complexes of 8-hydroxyquinoline or derivatives thereof, aromatic amine, tetraphenylcyclopentadiene or derivatives thereof, and tetraphenylbutadiene or derivatives thereof.
Specifically, light-emitting materials known in the art such as those described in, for example, JP-A-57-51781 and JP-A-59-194393 may be used.

When the light-emitting device of the present invention has a hole-transporting layer, examples of hole-transporting materials used include polyvinylcarbazole or derivatives thereof, polysilane or derivatives thereof, polysiloxane derivatives having aromatic amine in the side chain or the principal chain, pyrazoline derivatives, arylamine derivatives, stilbene derivatives, triphenyldiamine derivatives, polyaniline or derivatives thereof, polythiophene or derivatives thereof, polypyrrole or derivatives thereof, poly(p-phenylenevinylene) or derivatives thereof, and poly(2,5-thienylenevinylene) or derivatives thereof.
Specific examples of the hole-transporting material include those described in JP-A-63-70257, JP-A-63-175860, JP-A-2-135359, JP-A-2-135361, JP-A-2-209988, JP-A-3-37992, and JP-A-3-152184.
Among them, polymer hole-transporting materials such as polyvinylcarbazole or derivatives thereof, polysilane or derivatives thereof, polysiloxane derivatives having an aromatic amine compound group in the side chain or the principal chain, polyaniline or derivatives thereof, polythiophene or derivatives thereof, poly(p-phenylenevinylene) or derivatives thereof, and poly(2,5-thienylenevinylene) or derivatives thereof are preferable as the hole-transporting material used in the hole-transporting layer. Polyvinylcarbazole or derivatives thereof, polysilane or derivatives thereof, and polysiloxane derivatives having aromatic amine in the side chain or the principal chain are more preferable. It is preferred that a low-molecular-weight hole-transporting material, if used, should be dispersed in a polymer binder.

The polyvinylcarbazole or derivatives thereof are obtained, for example, from vinyl monomers by cationic polymerization or radical polymerization.

Examples of the polysilane or derivatives thereof include compounds described in Chem. Rev., vol. 89, p. 1359 (1989) and UK Patent No. GB2300196. Methods described in these documents can be used as a synthesis method thereof. Particularly, a Kipping method is preferably used.

Polysiloxane or derivatives thereof having a structure of the low-molecular-weight hole-transporting material in the side chain or the principal chain are preferably used because a siloxane skeleton structure has almost no hole-transporting properties. Particularly, examples of such polysiloxane or derivatives thereof include those having hole-transporting aromatic amine in the side chain or the principal chain.

A method for forming a film as the hole-transporting layer is not limited and is exemplified by, for the low-molecular-weight hole-transporting material, a method by which a film is formed from a mixture solution of the hole-transporting material with a polymer binder, or for the polymer hole-transporting material, a method by which a film is formed from a solution.

A solvent used in film formation from the solution is not particularly limited as long as the solvent permits for the dissolution of the hole-transporting material. Examples of the solvent include: chlorine-type solvents such as chloroform, methylene chloride, and dichloroethane; ether-type solvents such as tetrahydrofuran; aromatic hydrocarbon-type solvents such as toluene and xylene; ketone-type solvents such as acetone and methyl ethyl ketone; and ester-type solvents such as ethyl acetate, butyl acetate, and ethyl cellosolve acetate.

Examples of film formation methods from the solution include a film formation method from the liquid composition. Examples of the film formation method from the liquid composition that can be used include coating methods such as spin coating, casting, micro-gravure coating, gravure coating, bar coating, roll coating, wire bar coating, dip coating, spray coating, screen printing, flexographic printing, offset printing, and ink jet printing methods. Printing methods such as screen printing, flexographic printing, offset printing, and ink jet printing methods are preferable in terms of easy pattern formation or multicolor toning.

Polymer binders that do not extremely inhibit charge transport are preferable as the polymer binder to be mixed. Moreover, polymer binders that are not strongly absorbed to visible lights are preferably used. Examples of the polymer binder include polycarbonate, polyacrylate, polymethyl acrylate, polymethyl methacrylate, polystyrene, polyvinyl chloride, and polysiloxane.

The optimal film thickness value of the hole-transporting layer differs depending a material used and may be selected to give appropriate drive voltage and light-emitting efficiency values. The hole-transporting layer must have at least a thickness that prevents the generation of pin holes. An extremely large thickness increases the drive voltage of the device and therefore, is not preferable. Thus, the film thickness of the hole-transporting layer is, for example, 1 nm to 1 µm, preferably 2 nm to 500 nm, more preferably 5 nm to 200 nm.

When the light-emitting device of the present invention has an electron-transporting layer, electron-transporting materials known in the art can be used. Examples thereof include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof, and polyfluorene or derivatives thereof.

Specific examples thereof include those described in JP-A-63-70257, JP-A-63-175860, JP-A-2-135359, JP-A-2-135361, JP-A-2-209988, JP-A-3-37992, and JP-A-3-152184.

Of them, aminoxadiazole derivatives, benzoquinone or derivatives thereof, anthraquinone or derivatives thereof, or metal complexes of 8-hydroxyquinoline or derivatives thereof, polyquinoline or derivatives thereof, polyquinoxaline or derivatives thereof, and polyfluorene or derivatives thereof are preferable. 2-(4-biphenylyl)-5-(4-t-butylphenyl)-1,3,4-oxadiazole, benzoquinone, anthraquinone, tris(8-quinolinol)aluminum, and polyquinoline are more preferable.

A method for forming a film as the electron-transporting layer is not particularly limited and is exemplified by, for the low-molecular-weight electron-transporting material, a method by which a film is formed from a powder by a vacuum deposition method or from a solution or a melted state, or for the polymer electron-transporting material, a method by which a film is formed from a solution or a melted state. In film formation from the solution or the melted state, a polymer binder may be used in combination therewith.

A solvent used in film formation from the solution is not particularly limited as long as the solvent permits for the dissolution of the electron-transporting material and/or the polymer binder. Examples of the solvent include: chlorine-type solvents such as chloroform, methylene chloride, and dichloroethane; ether-type solvents such as tetrahydrofuran; aromatic hydrocarbon-type solvents such as toluene and xylene; ketone-type solvents such as acetone and methyl ethyl ketone; and ester-type solvents such as ethyl acetate, butyl acetate, and ethyl cellosolve acetate.

Examples of film formation methods from the solution or the melted state that can be used include coating methods such as spin coating, casting, micro-gravure coating, gravure coating, bar coating, roll coating, wire bar coating, dip coating, spray coating, screen printing, flexographic printing, offset printing, and ink jet printing methods.

Polymer binders that do not extremely inhibit charge transport are preferable as the polymer binder to be mixed. Moreover, polymer binders that are not strongly absorbed to visible lights are preferably used. Examples of the polymer binder include poly(N-vinylcarbazole), polyaniline or derivatives thereof, polythiophene or derivatives thereof, poly(p-phenylenevinylene) or derivatives thereof, poly(2,5-thienylenevinylene) or derivatives thereof, polycarbonate, polyacrylate, polymethyl acrylate, polymethyl methacrylate, polystyrene, polyvinyl chloride, and polysiloxane.

The optimal film thickness value of the electron-transporting layer differs depending a material used and may be selected to give appropriate drive voltage and light-emitting efficiency values. The hole-transporting layer must have at least a thickness that prevents the generation of pin holes. An extremely large thickness increases the drive voltage of the device and therefore, is not preferable. Thus, the film thickness of the electron-transporting layer is, for example, 1 nm to 1 µm, preferably 2 nm to 500 nm, more preferably 5 nm to 200 nm.

Any substrate can be used to form the light-emitting device of the present invention as long as the substrate forms the electrode and is not altered in the formation of each layer of the light-emitting device. Examples thereof include glass, plastics, polymer films, and silicon substrates. When the substrate is opaque, it is preferred that the electrode on the opposite side should be transparent or semi-transparent.

At least one of the electrodes comprising an anode and a cathode is usually transparent or semi-transparent. It is preferred that the anode should be transparent or semi-transparent.
Conductive metal oxide films, semi-transparent metal thin films, and so on are used as materials for the anode. Specific examples of the materials used include: films (e.g., NESA) prepared using conductive glass comprising indium oxide, zinc oxide, tin oxide, and complexes thereof (e.g., indium tin oxide (ITO) or indium zinc oxide); and gold, platinum, silver, and copper. ITO, indium zinc oxide, and tin oxide are preferable. Examples of production methods thereof include vacuum deposition, sputtering, ion plating, and plating methods. Alternatively, organic transparent conductive films such as polyaniline or derivatives thereof and polythiophene or derivatives thereof may be used as the anode.

The film thickness of the anode can be selected appropriately in consideration of light permeability and electric conductivity and is, for example, 10 nm to 10 µm, preferably, 20 nm to 1 µm, more preferably 50 nm to 500 nm.

Moreover, for facilitating charge injection, a layer comprising a phthalocyanine derivative, a conductive polymer, carbon, or the like or a layer of 2 nm or smaller in average film thickness comprising a metal oxide or a metal fluoride, an organic insulating material, or the like may be provided on the anode.

Materials having a small work function are preferable as materials for the cathode used in the light-emitting device of the present invention. Examples of the materials used include: metals such as lithium, sodium, potassium, rubidium, caesium, beryllium, magnesium, calcium, strontium, barium, aluminum, scandium, vanadium, zinc, yttrium, indium, cerium, samarium, europium, terbium, and ytterbium; alloys of two or more of the metals; alloys of one or more of the metals with one or more of gold, silver, platinum, copper, manganese, titanium, cobalt, nickel, tungsten, and tin; and graphite or intercalated graphite. Examples of the alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. The cathode may be used as a layered structure comprising two or more layers.

The film thickness of the cathode can be selected appropriately in consideration of electric conductivity and durability and is, for example, 10 nm to 10 µm, preferably 20 nm to 1 µm, more preferably 50 nm to 500 nm.

For example, a vacuum deposition method, a sputtering method, or a laminating method using the thermocompression bonding of a metal thin film is used as a production method of the cathode. Moreover, a layer comprising a conductive polymer or a layer of 2 nm or smaller in average film thickness comprising a metal oxide or a metal fluoride, an organic insulating material, or the like may be provided between the cathode and the organic layer. After cathode production, a protective layer for protecting the light-emitting device may be provided thereon. It is preferred for using the light-emitting device with long-term stability that a protective layer and/or a protective cover should be provided thereon to protect the device from outside.

Polymer compounds, metal oxides, metal fluorides, metal borides, and so on can be used as the protective layer. Alternatively, glass plates, plastic plates surface-treated for a low coefficient of water permeability, and so on can be used as the protective cover. A method is preferably used, by which the cover is bonded to the device substrate by use of a thermosetting resin or a photocurable resin for hermetical sealing. Space is maintained with a spacer to thereby prevent damages in the device. Inactive gas such as nitrogen or argon can be held in the space to thereby easily prevent the oxidation of the cathode. Furthermore, a desiccating agent such as barium oxide is placed in the space to thereby easily suppress damages in the device attributed to moistures adsorbed during the production process. It is preferred that any one or more of these methods should be adopted.

The material of the present invention can also be used as a conductive material or a semiconductor material. The conductive thin film or the organic semiconductor thin film can be formed for device production by the same method as the method for producing the light-emitting device described above. It is preferred that the semiconductor thin film should have an electron mobility or a hole mobility (whichever is lager) of 10⁻⁵ cm²/V/second or larger. The light-emitting device using the material of the present invention can be used in a planar light source, a segment display, a dot matrix, a backlight for a liquid crystal display, or illumination.

To obtain light emission in a planar form using the light-emitting device of the present invention, a planar anode and a planar cathode may be placed to overlap each other. Alternatively, to obtain light emission in a pattern form, methods can be used, which include: a method by which a mask provided with a window in a pattern form is placed on the surface of the planar light-emitting device; a method by which an organic layer in a non-light-emitting part is formed at an extremely large thickness to provide substantially no light emission; and a method by which either the anode or the cathode or both the electrodes are formed in a pattern form. A pattern is formed by any of these methods, and some electrodes are placed so that the electrodes can independently be switched on/off. As a result, a segment-type display device that can display numbers, characters, simple symbols, and so on can be obtained. Furthermore, to prepare the dot matrix device, both the anode and the cathode may be formed in a stripe form and placed orthogonal to each other. Partial color display or multicolor display can be performed by a method for multicolor toning with plural light-emitting materials differing in the colors of emitted lights or a method using a color filter or a light conversion filter. The dot matrix device may be driven passively or may be driven actively in combination with TFT or the like. These display devices can be used as displays in computers, televisions, mobile terminals, mobile phones, car navigators, viewfinders for video cameras, and so on.

Furthermore, the planar light-emitting device is a self-light-emitting flat type and can be used preferably as a planar light source for a backlight of a liquid crystal display or a planar light source for illumination. Alternatively, the light-emitting device of the present invention can also be used as a curved-surface light source or display by using a flexible substrate.

Next, a photoelectric device will be described as another aspect of the present invention.
The photoelectric device is, for example, a photoelectric conversion device. Examples thereof include: a device in which a layer containing the metal complex or the composition of the present invention is held between two sets of electrodes, at least one of which is transparent or semi-transparent; and a device having a comb-like electrode formed on a film formed as a layer containing the polymer compound or the polymer composition of the present invention on a substrate. To improve the characteristics, fullerene, carbon nanotube, or the like may be mixed therewith.
Examples of a method for producing the photoelectric conversion device include a method described in Japanese Patent No. 3146296. Specific examples thereof include a method comprising forming a polymer thin film onto a substrate having a first electrode and forming a second electrode thereon and a method comprising forming a polymer thin film onto a set of comb-like electrodes formed on a substrate. One of the first and second electrodes is transparent or semi-transparent.
A method for forming the polymer thin film or a method for mixing fullerene or carbon nanotube is not particularly limited. Those exemplified for the light-emitting device can be utilized preferably.
The present invention also relates to the photoelectric device as a switching device, the photoelectric device as a photoelectric conversion device, a planar light source characterized by using the light-emitting device, a segment display characterized by using the light-emitting device, a dot matrix display characterized by using the light-emitting device, a liquid crystal display characterized by using the light-emitting device as a backlight, illumination using the light-emitting device, a liquid crystal or light-emitting display having an active matrix drive circuit mainly constructed from the switching device, and a solar cell using the photoelectric conversion device.

### Examples

Hereinafter, the present invention will be described in further detail with reference to Examples. However, the present invention is not limited to these Examples.

### Reference Example 1

A metal complex (1-1) below was added at a proportion of 5 wt% to a compound (H-1) below. The resulting mixture was prepared as a 0.8 wt% chloroform solution.
A solution of poly(ethylenedioxythiophene)/polystyrene sulfonic acid (Bayer, Baytron P) was used to form a film of the solution at a thickness of 50 nm by spin coating in a glass substrate coated with an ITO film at a thickness of 150 nm by a sputtering method. The film was dried at 200°C for 10 minutes on a hot plate. Next, the prepared chloroform solution was used to form a film of the mixture of the metal complex (1-1) below and the charge-transporting material (H-1) below by spin coating at a rotation speed of 3000 rpm. Its film thickness was approximately 100 nm. Furthermore, this film was dried at 80°C for 1 hour under reduced pressure. Then, approximately 4 nm of LiF as a cathode buffer layer as well as approximately 5 nm of calcium as and subsequently, approximately 80 nm of aluminum a cathode was deposited thereonto to prepare an EL device. After the degree of vacuum reached 1×10⁻⁴ Pa or less, the metal deposition was initiated. A voltage was applied to the obtained device to thereby obtain orange EL light emission. 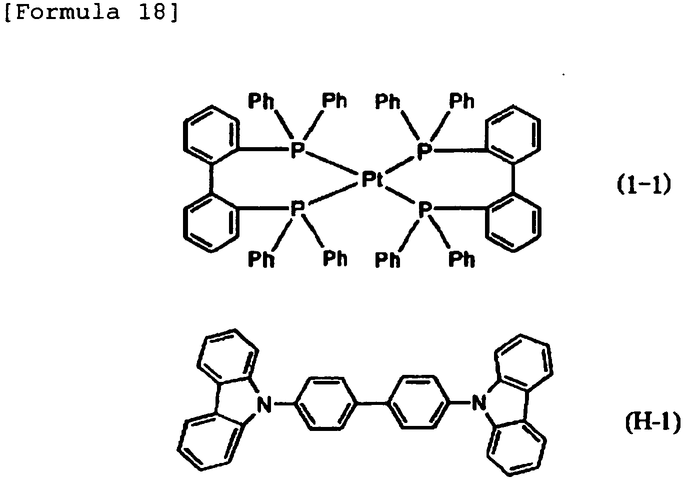 In this context, the metal complex compound (1-1) was synthesized according to a method described in Journal of the Chemistry Society Chemical Communications, p. 2273-2274 (1995). The compound (H-1) used was manufactured by Tokyo Chemical Industry Co., Ltd.

### Example 2

A metal complex (1-2) below was added at a proportion of 5 wt% to a polymer compound (H-2) below. The resulting mixture was prepared as a 1.5 wt% toluene solution. A film of the mixture was formed in the same way as in Example 1 to prepare a device. The number of revolutions of a spin coater in the film formation was 1800 rpm, and the film thickness was approximately 100 nm. A voltage was applied to the obtained device to thereby obtain orange EL light emission. 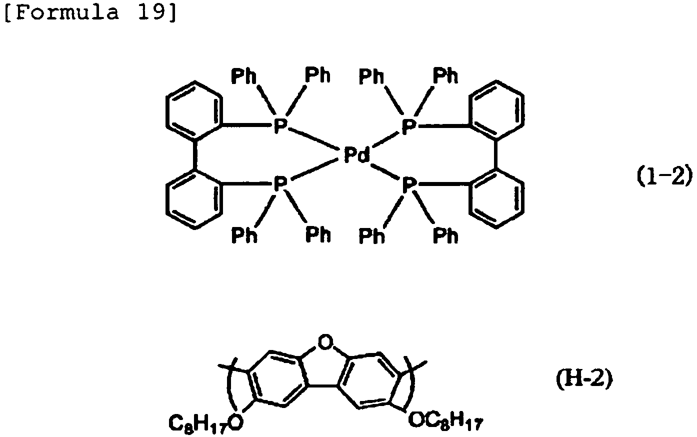 In this context, the metal complex compound (1-2) was synthesized according to a method described in Journal of the American Chemical Society, vol. 122, p. 4618-4630 (2000). The compound (H-2) was synthesized by a method described in JP-A-2004-59899.

### Example 3

The metal complex (1-2) described in Example 2 was added at a proportion of 3 wt% to a 70:30 (weight ratio) mixture of the polymer (H-2) described in Example 2 and a polymer (H-3) below. The resulting mixture was prepared as a 1.7 wt% toluene solution. A film of the mixture was formed in the same way as in Example 1 to prepare a device. The number of revolutions of a spin coater in the film formation was 1800 rpm, and the film thickness was approximately 100 nm. A voltage was applied to the obtained device to thereby obtain white EL light emission. 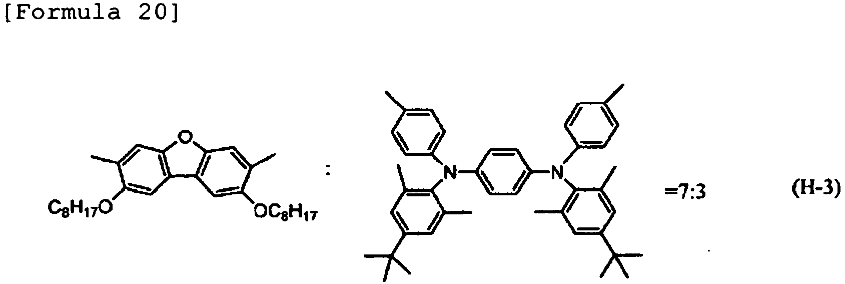 The compound (H-3) was synthesized by a method described in JP-A-2004-59899.

### INDUSTRIAL APPLICABILITY

A metal complex material of the present invention offers easy synthesis and has favorable photoelectric characteristics. The metal complex material of the present invention can be used in a photoelectric device.

## Claims

1. A material **characterized in that** the material is a composition containing a neutral metal complex and a charge-transporting material which is a conjugated polymer, the neutral metal complex having a partial structure represented by the general formula (1) below and at least two multidentate ligands, or is a conjugated polymer containing in its molecule a residue of the metal complex and a residue of the charge-transporting material: 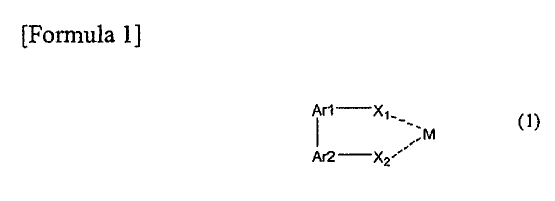 wherein M represents a transition metal or a lanthanoid; Ar1 and Ar2 each independently represent an optionally substituted divalent aromatic ring; and X₁ and X₂ each independently represent P(Ar3) (Ar4), S, or O, wherein Ar3 and Ar4 each independently represent an optionally substituted monovalent aromatic ring, and the broken line in the formula represents a coordinate bond between a multidentate ligand and the metal.

2. The material according to claim 1, wherein the material is a composition containing a metal complex having a partial structure represented by the general formula (1) and a charge-transporting material, which is a conjugated polymer.

3. The material according to claim 1, wherein the material is a conjugated polymer containing in its molecule a residue of a metal complex having a partial structure represented by the general formula (1) and a residue of a charge-transporting material.

4. The material according to claim 2, wherein the charge-transporting material is a conjugated polymer containing in its molecule a residue of a metal complex having a partial structure represented by the general formula (1) and a residue of a charge-transporting material.

5. A material according to claim 3 or 4, wherein the material further contains at least one material selected from the group consisting of hole-transporting materials, electron-transporting materials, and light-emitting materials.

6. The material according to any one of claims 1 to 5, wherein the charge-transporting material is selected from the group consisting of an aromatic amine, a carbazole derivative, a polyparaphenylene derivative, an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or a metal complex of 8-hydroxyquinoline or a derivative thereof, a host compound for use in low-molecular-weight organic EL devices, a charge-injecting/transporting compound, polyvinylcarbazole, a polymer containing an aromatic ring in the principal chain and containing an optionally substituted phenylene group, fluorene, dibenzothiophene, dibenzofuran, or dibenzosilol as a repeating unit in the principal chain, and a copolymer with these units.

7. The material according to any one of claims 1 to 5, wherein the polymer contains a structure selected from the group consisting of an aromatic amine, a carbazole derivative, a polyparaphenylene derivative, an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or a metal complex of 8-hydroxyquinoline or a derivative thereof, a host compound for use in low-molecular-weight organic EL devices, a charge-injecting/transporting compound, polyvinylcarbazole, a polymer containing an aromatic ring in the principal chain and containing an optionally substituted phenylene group, fluorene, dibenzothiophene, dibenzofuran, or dibenzosilol as a repeating unit in the principal chain, and a copolymer with these units.

8. The material according to claim 6 or 7, wherein the material has an optionally substituted benzene ring and/or a partial structure represented by the general formula (2) below: 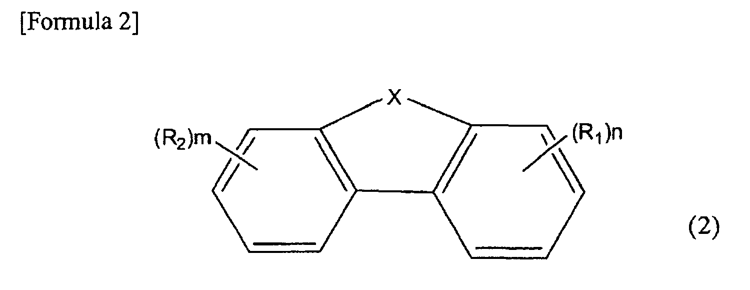 wherein X represents N, O, S, Se, B, Si, P, C, C-C, O-C, S-C, N-C, Si-C, Si-Si, C=C, or Si=C and is optionally substituted depending on its valence. R₁ and R₂ each independently represent a hydrogen atom, a halogen atom, an alkyl group, an alkoxy group, an aryl group, or a bond to another atom; and m and n each independently represent an integer of 0 to 4.

9. The material according to claim 8, wherein in the formula (2), -X-represents -O-, -S-, -Se-, B(R₃₁)-, -Si(R₃₂)(R₃₃)-, -P(R₃₄)-, -PR₃₆(=O)-, -C(R₃₇)(R₃₈)-, -C(R₅₁)(R₅₂)-C(R₅₃)(R₅₄)-, -O-C(R₅₅)(R₅₆)-, -S-C(R₅₇)(R-₅₈)-, -N-C(R₅₉)(R₆₀)-, -Si(R₆₁)(R₆₂)-C(R₆₃)(R₆₄)-, -Si(R₆₅)(R₆₆)-Si(R₆₇)(R₆₈)-, -C(R₆₉)=C(R₇₀)-, -N(R₃₅)-, -N=C(R₇₁)-, or -Si(R₇₂)=C(R₇₃)-, wherein R₃₁ to R₃₈ and R₅₁ to R₇₃ each independently represent an alkyl group, an alkoxy group, an alkylthio group, an aryl group, an aryloxy group, an arylthio group, an arylalkyl group, an arylalkoxy group, an arylalkylthio group, an arylalkenyl group, an arylalkynyl group, a monovalent heterocyclic group, or a halogen atom.

10. The material according to claim 8, wherein in the formula (2), -X- is represented by the general formula (3) below: 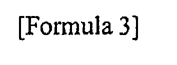 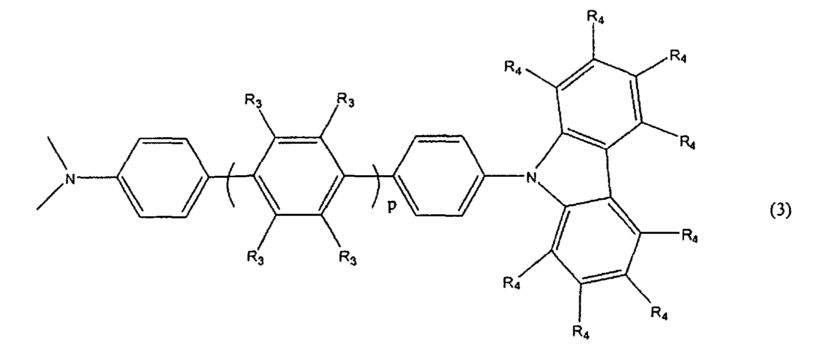 wherein R3 and R4 each independently represent an alkyl group optionally substituted by fluorine, an alkoxy group, an aryl group, or a halogen atom and do not have to be the same within one unit; and p is 0 or 1.

11. The material according to any one of claims 1 to 14, wherein the metal complex has a structure represented by the general formula (1A) below: 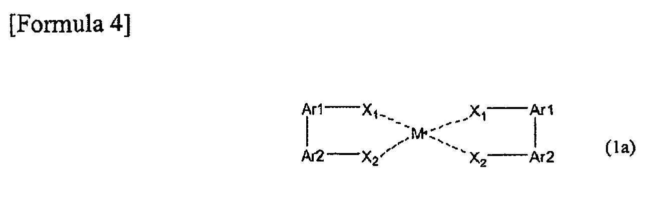 wherein M represents a transition metal or a lanthanoid; Ar1 and Ar2 each independently represent an optionally substituted divalent aromatic ring; and X₁ and X₂ each independently represent P(Ar3)(Ar4), S, or O, wherein Ar3 and Ar4 each independently represent an optionally substituted monovalent aromatic ring, and the broken line in the formula represents a coordinate bond between a multidentate ligand and the metal.

12. The material according to any one of claims 1 to 11, wherein the metal complex is represented by the formula below: 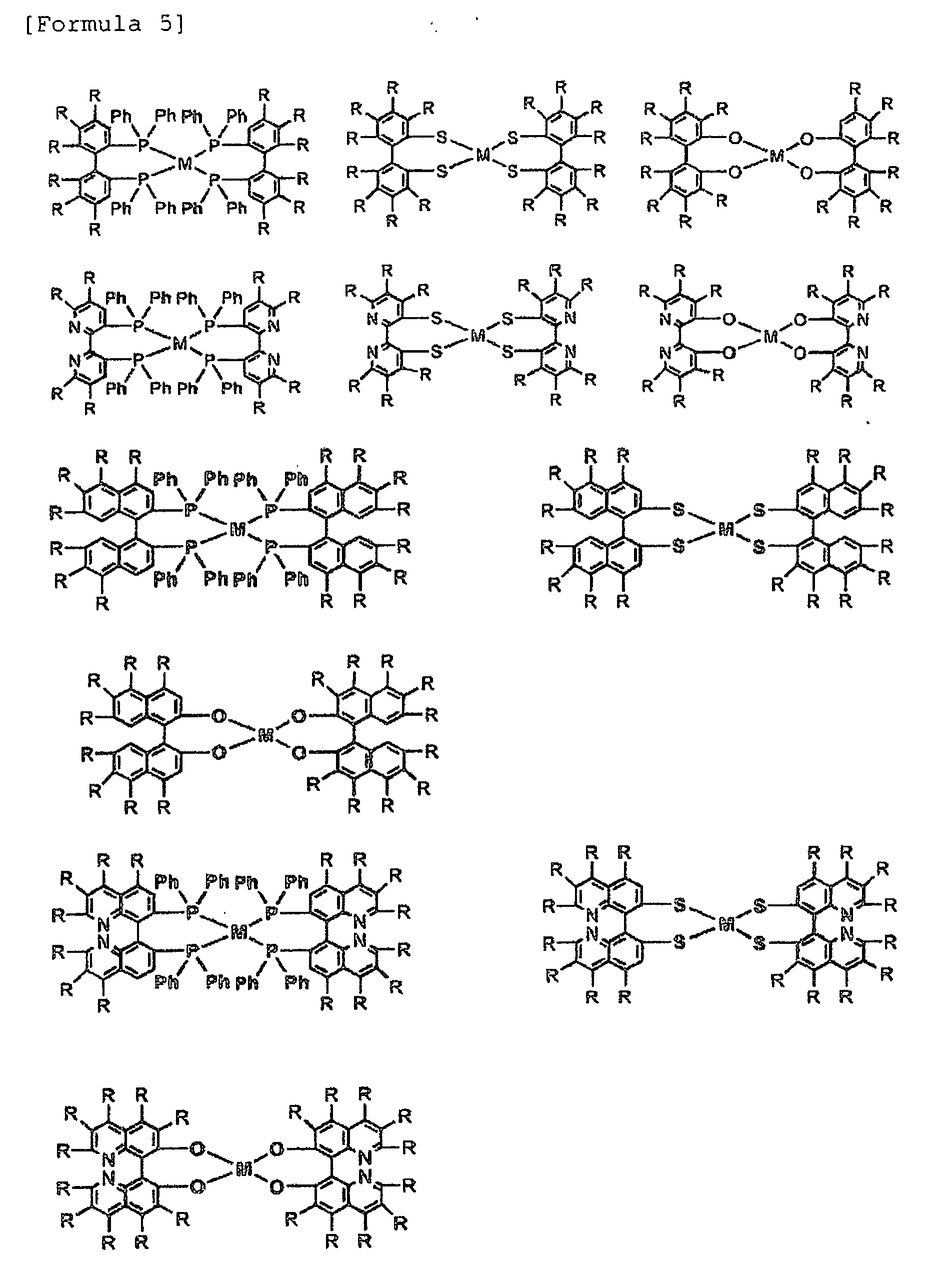 wherein M is selected from the group consisting of Ru, Rh, Pd, W, Ir, Pt, and Au; and R is selected from the group consisting of a halogen atom, an alkyl group, an alkyloxy group, an alkylthio group, an aryl group, an aryloxy group, an arylthio group, an arylalkyl group, an arylalkyloxy group, an arylalkylthio group, an acyl group, an acyloxy group, an amide group, an acid imide group, an imine residue, a substituted amino group, a substituted silyl group, a substituted silyloxy group, a substituted silylthio group, a substituted silylamino group, a monovalent heterocyclic group, a heteroaryloxy group, a heteroarylthio group, an arylalkenyl group, and an arylethynyl group, and a plurality of R groups can be identical or different.

13. A liquid composition **characterized by** comprising a material according to any one of claims 1 to 12.

14. The liquid composition according to claim 13, wherein the liquid composition has a viscosity of 1 to 100 mPa·s at 25°C.

15. A light-emitting thin film, conductive thin film or organic semiconductor thin film **characterized by** comprising a material according to any one of claims 1 to 12.

16. A photoelectric device **characterized by** comprising a material according to any one of claims 1 to 12.

17. The photoelectric device according to claim 16, **characterized in that** the photoelectric device has a layer containing the metal complex or the material according to any one of claims 1 to 12 between electrodes comprising an anode and a cathode.

18. The photoelectric device according to claim 16 or 17, wherein the photoelectric device further comprises a charge-transporting layer or a charge-blocking layer between the electrodes comprising an anode and a cathode.

19. The photoelectric device according to any one of claims 16 to 18, wherein the photoelectric device is a light-emitting device.

20. The photoelectric device according to any one of claims 16 to 18, wherein the photoelectric device is a switching device.

21. The photoelectric device according to any one of claims 16 to 18, wherein the photoelectric device is a photoelectric conversion device.

22. A planar light source, segment display, dot matrix display, or illumination **characterized by** using a light-emitting device according to claim 19; or a liquid crystal display **characterized by** using a light-emitting device according to claim 19 as a backlight.

23. A liquid crystal display having an active matrix drive circuit mainly constructed from a switching device according to claim 20.

24. A solar cell using the photoelectric conversion device according to claim 21.

## Patentansprüche

1. Ein Material, **dadurch gekennzeichnet, dass** das Material eine Zusammensetzung ist, die einen neutralen Metallkomplex und ein Ladungstransport-Material, welches ein konjugiertes Polymer ist, enthält, wobei der neutrale Metallkomplex eine Teilstruktur, die durch die allgemeine Formel (1) unten dargestellt ist, und mindestens zwei mehrzähnige Liganden aufweist, oder ein konjugiertes Polymer ist, das in seinem Molekül einen Rest des Metallkomplexes und einen Rest des Ladungstransport-Materials enthält: 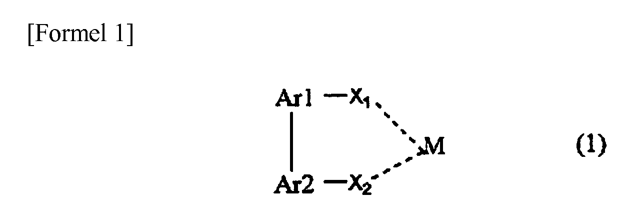 wobei M ein Übergangsmetall oder ein Lanthanoid darstellt; Ar1 und Ar2 jeweils unabhängig einen gegebenenfalls substituierten, zweiwertigen aromatischen Ring darstellen; und X₁ und X₂ jeweils unabhängig P(Ar3)(Ar4), S oder O darstellen, wobei Ar3 und Ar4 jeweils unabhängig einen gegebenenfalls substituierten, einwertigen aromatischen Ring darstellen und die gestrichelte Linie in der Formel eine koordinative Bindung zwischen einem mehrzähnigen Liganden und dem Metall darstellt.

2. Das Material gemäß Anspruch 1, wobei das Material eine Zusammensetzung ist, die einen Metallkomplex, der eine Teilstruktur, die durch die allgemeine Formel (1) dargestellt ist, aufweist, und ein Ladungstransport-Material, welches ein konjugiertes Polymer ist, enthält.

3. Das Material gemäß Anspruch 1, wobei das Material ein konjugiertes Polymer ist, das in seinem Molekül einen Rest eines Metallkomplexes, der eine Teilstruktur, die durch die allgemeine Formel (1) dargestellt ist, aufweist, und einen Rest eines Ladungstransport-Materials enthält.

4. Das Material gemäß Anspruch 2, wobei das Ladungstransport-Material ein konjugiertes Polymer ist, das in seinem Molekül einen Rest eines Metallkomplexes, der eine Teilstruktur, die durch die allgemeine Formel (1) dargestellt ist, aufweist, und einen Rest eines Ladungstransport-Materials enthält.

5. Ein Material gemäß Anspruch 3 oder 4, wobei das Material ferner mindestens ein Material enthält, das aus der Gruppe bestehend aus Lochtransport-Materialien, Elektrontransportmaterialien und lichtemittierenden Materialien ausgewählt ist.

6. Das Material gemäß einem der Ansprüche 1 bis 5, wobei das Ladungstransport-Material aus der Gruppe bestehend aus einem aromatischen Amin, einem Carbazolderivat, einem Polyparaphenylenderivat, einem Oxadiazolderivat, Anthrachinondimethan oder einem Derivat davon, Benzochinon oder einem Derivat davon, Naphthochinon oder einem Derivat davon, Anthrachinon oder einem Derivat davon, Tetracyanoanthrachinondimethan oder einem Derivat davon, einem Fluorenonderivat, Diphenyldicyanoethylen oder einem Derivat davon, einem Diphenochinonderivat oder einem Metallkomplex von 8-Hydroxychinolin oder einem Derivat davon, einer Wirtsverbindung zur Verwendung in organischen elektrolumineszierenden Vorrichtungen mit niederem Molekulargewicht, einer ladungsinjizierenden/ladungstransportierenden Verbindung, Polyvinylcarbazol, einem Polymer, das einen aromatischen Ring in der Hauptkette enthält und einen gegebenenfalls substituierten Phenylenrest, Fluoren, Dibenzothiophen, Dibenzofuran oder Dibenzosilol als Wiederholungseinheit in der Hauptkette enthält, und einem Copolymer mit diesen Einheiten, ausgewählt ist.

7. Das Material gemäß einem der Ansprüche 1 bis 5, wobei das Polymer eine Struktur enthält, die aus der Gruppe bestehend aus einem aromatischen Amin, einem Carbazolderivat, einem Polyparaphenylenderivat, einem Oxadiazolderivat, Anthrachinondimethan oder einem Derivat davon, Benzochinon oder einem Derivat davon, Naphthochinon oder einem Derivat davon, Anthrachinon oder einem Derivat davon, Tetracyanoanthrachinondimethan oder einem Derivat davon, einem Fluorenonderivat, Diphenyldicyanoethylen oder einem Derivat davon, einem Diphenochinonderivat oder einem Metallkomplex von 8-Hydroxychinolin oder einem Derivat davon, einer Wirtsverbindung zur Verwendung in organischen elektrolumineszierenden Vorrichtungen mit niederem Molekulargewicht, einer ladungsinjizierenden/ladungstransportierenden Verbindung, Polyvinylcarbazol, einem Polymer, das einen aromatischen Ring in der Hauptkette enthält und einen gegebenenfalls substituierten Phenylenrest, Fluoren, Dibenzothiophen, Dibenzofuran oder Dibenzosilol als Wiederholungseinheit in der Hauptkette enthält, und einem Copolymer mit diesen Einheiten, ausgewählt ist.

8. Das Material gemäß Anspruch 6 oder 7, wobei das Material einen gegebenenfalls substituierten Benzolring und/oder eine Teilstruktur, die durch die allgemeine Formel (2) unten dargestellt ist, aufweist: 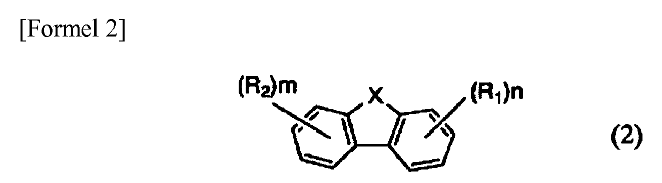 wobei X gleich N, O, S, Se, B, Si, P, C, C-C, O-C, S-C, N-C, Si-C, Si-Si, C=C oder Si=C darstellt und abhängig von seiner Wertigkeit gegebenenfalls substituiert ist, R₁ und R₂ jeweils unabhängig ein Wasserstoffatom, ein Halogenatom, einen Alkylrest, einen Alkoxyrest, einen Arylrest oder eine Bindung zu einem weiteren Atom darstellen; und m und n jeweils unabhängig eine ganze Zahl von 0 bis 4 darstellen.

9. Das Material gemäß Anspruch 8, wobei in der Formel (2), -X- gleich -O-, -S-, -Se-, B(R₃₁)-, -Si(R₃₂)(R₃₃)-, -P(R₃₄)-, -PR₃₆(=O)-, -C(R₃₇)(R₃₈)-, -C(R₅₁)(R₅₂)-C(R₅₃)(R₅₄)-, -O-C(R₅₅)(R₅₆)-, -S-C(R₅₇)(R₅₈)-, -N-C(R₅₉)(R₆₀)-, -Si(R₆₁)(R₆₂)-C(R₆₃)(R₆₄)-, -Si(R₆₅)(R₆₆)-Si(R₆₇)(R₆₈)-, -C(R₆₉)=C(R₇₀)-, -N(R₃₅)-, -N=C(R₇₁)- oder -Si(R₇₂)=C(R₇₃)-ist, wobei R₃₁ bis R₃₈ und R₅₁ bis R₇₃ jeweils unabhängig einen Alkylrest, einen Alkoxyrest, einen Alkylthiorest, einen Arylrest, einen Aryloxyrest, einen Arylthiorest, einen Arylalkylrest, einen Arylalkoxyrest, einen Arylalkylthiorest, einen Arylalkenylrest, einen Arylalkinylrest, einen einwertigen heterocyclischen Rest oder ein Halogenatom darstellen.

10. Das Material gemäß Anspruch 8, wobei in der Formel (2) -X- wie durch die allgemeine Formel (3) unten dargestellt ist: 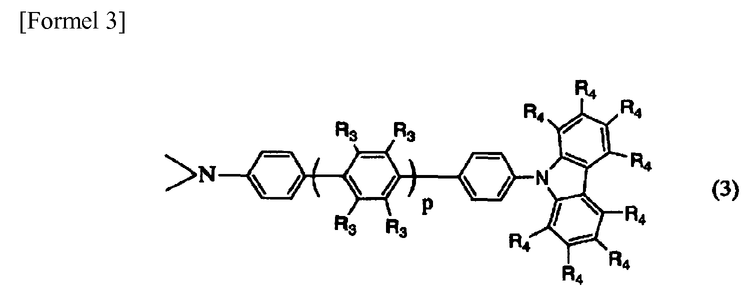 wobei R₃ und R₄ jeweils unabhängig einen Alkylrest, der gegebenenfalls mit einem Fluor subsituiert ist, einen Alkoxyrest, einen Arylrest oder ein Halogenatom darstellen und diese innerhalb einer Einheit nicht gleich sein müssen; und p gleich 0 oder 1 ist.

11. Das Material gemäß einem der Ansprüche 1 bis 10, wobei der Metallkomplex eine Struktur, wie durch die allgemeine Formel (1A) unten dargestellt, aufweist: 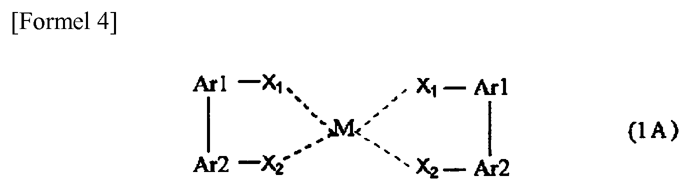 wobei M ein Übergangsmetall oder ein Lanthanoid darstellt; Ar1 und Ar2 jeweils unabhängig einen gegebenenfalls substituierten zweiwertigen aromatischen Ring darstellen; und X₁ und X₂ jeweils unabhängig P(Ar3)(Ar4), S oder O darstellen, wobei Ar3 und Ar4 jeweils unabhängig einen gegebenenfalls substituierten, einwertigen aromatischen Ring darstellen und die gestrichelte Linie in der Formel eine koordinative Bindung zwischen einem mehrzähnigen Liganden und dem Metall darstellt.

12. Das Material gemäß einem der Ansprüche 1 bis 11, wobei der Metallkomplex durch die nachstehende Formel dargestellt ist: 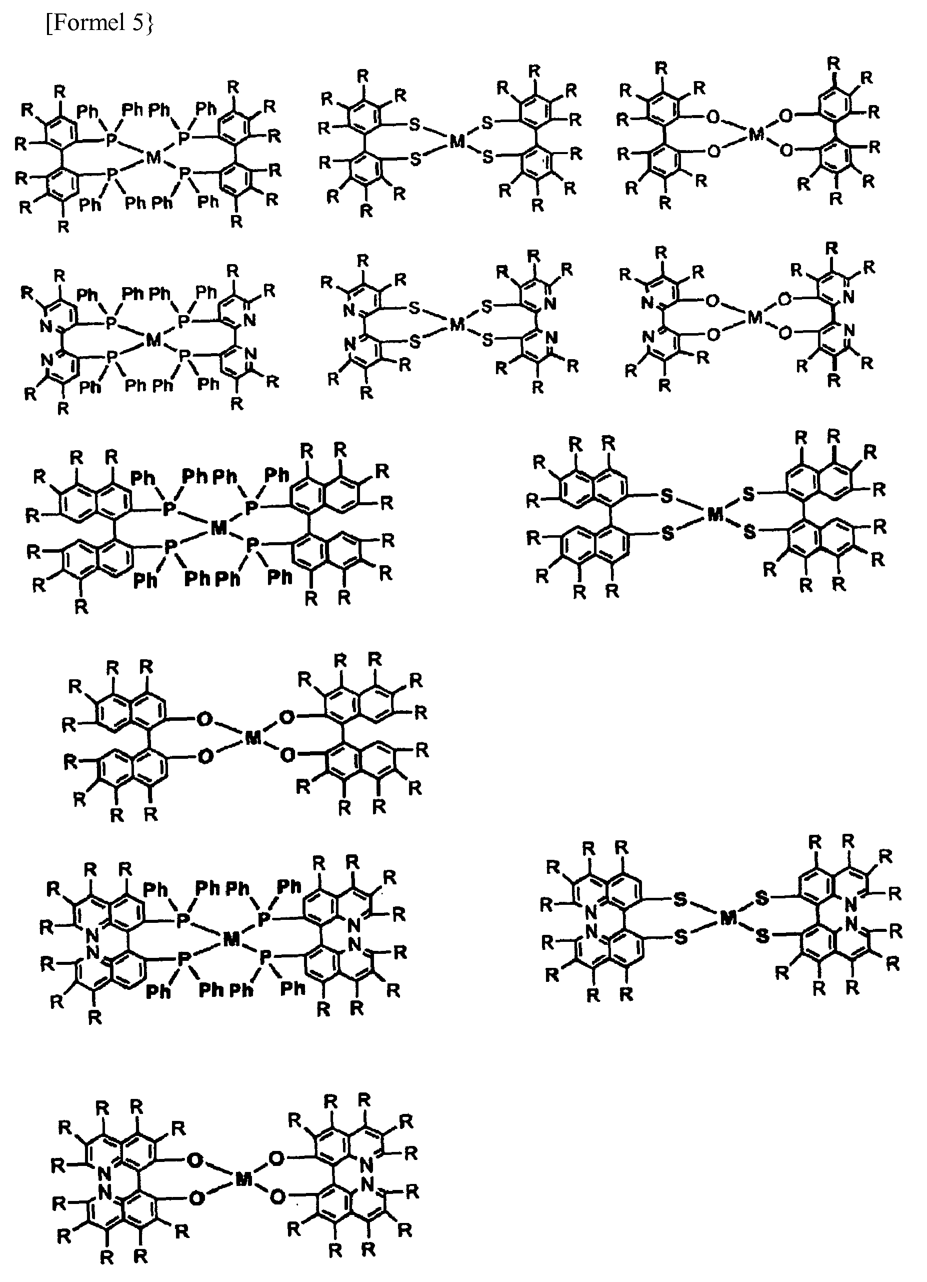 wobei M aus der Gruppe bestehend aus Ru, Rh, Pd, W, Ir, Pt und Au ausgewählt ist; und R aus der Gruppe bestehend aus einem Halogenatom, einem Alkylrest, einem Alkyloxyrest, einem Alkylthiorest, einem Arylrest, einem Aryloxyrest, einem Arylthiorest, einem Arylalkylrest, einem Arylalkyloxyrest, einem Arylalkylthiorest, einem Acylrest, einem Acyloxyrest, einem Amidrest, einem sauren Imidrest, einem Iminrest, einem substituierten Aminorest, einem substituierten Silylrest, einem substituierten Silyloxyrest, einem substituierten Silylthiorest, einem substituierten Silylaminorest, einem einwertigen heterocyclischen Rest, einem Heteroaryloxyrest, einem Heteroarylthiorest, einem Arylalkenylrest und einem Arylethinylrest ausgewählt ist und mehrere Reste R gleich oder verschieden sein können.

13. Eine flüssige Zusammensetzung, **dadurch gekennzeichnet, dass** sie ein Material gemäß einem der Ansprüche 1 bis 12 umfasst.

14. Die flüssige Zusammensetzung gemäß Anspruch 13, wobei die flüssige Zusammensetzung eine Viskosität von 1 bis 100 mPa·s bei 25°C aufweist.

15. Eine lichtemittierende Dünnschicht, leitfähige Dünnschicht oder organische Halbleiter-Dünnschicht, **dadurch gekennzeichnet, dass** sie ein Material gemäß einem der Ansprüche 1 bis 12 umfasst.

16. Eine photoelektrische Vorrichtung, **dadurch gekennzeichnet, dass** sie ein Material gemäß einem der Ansprüche 1 bis 12 umfasst.

17. Die photoelektrische Vorrichtung gemäß Anspruch 16, **dadurch gekennzeichnet, dass** die photoelektrische Vorrichtung eine Schicht, die den Metallkomplex oder das Material gemäß einem der Ansprüche 1 bis 12 enthält, zwischen Elektroden, die eine Anode und eine Kathode umfassen, aufweist.

18. Die photoelektrische Vorrichtung gemäß Anspruch 16 oder 17, wobei die photoelektrische Vorrichtung ferner eine Ladungstransport-Schicht oder eine Ladungsblockier-Schicht zwischen den Elektroden, die eine Anode und eine Kathode umfassen, aufweist.

19. Die photoelektrische Vorrichtung gemäß einem der Ansprüche 16 bis 18, wobei die photoelektrische Vorrichtung eine lichtemittierende Vorrichtung ist.

20. Die photoelektrische Vorrichtung gemäß einem der Ansprüche 16 bis 18, wobei die photoelektrische Vorrichtung eine Schaltvorrichtung ist.

21. Die photoelektrische Vorrichtung gemäß einem der Ansprüche 16 bis 18, wobei die photoelektrische Vorrichtung eine photoelektrische Umwandlungsvorrichtung ist.

22. Eine planare Lichtquelle, Segmentanzeige, Punktmatrixanzeige oder Beleuchtung, **dadurch gekennzeichnet, dass** sie eine lichtemittierende Vorrichtung gemäß Anspruch 19 verwendet; oder eine Flüssigkristallanzeige, **dadurch gekennzeichnet dass** sie eine lichtemittierende Vorrichtung gemäß Anspruch 19 als Hintergrundbeleuchtung verwendet.

23. Eine Flüssigkristallanzeige, die eine Aktive-Matrix-Ansteuerschaltung, welche hauptsächlich durch eine Schaltvorrichtung gemäß Anspruch 20 aufgebaut ist, aufweist.

24. Eine Solarzelle, welche die photoelektrische Umwandlungsvorrichtung gemäß Anspruch 21 verwendet.

## Revendications

1. Matériau, **caractérisé en ce que** le matériau est une composition comprenant un complexe métallique neutre et un matériau transporteur de charges qui est un polymère conjugué, le complexe métallique neutre ayant une structure partielle représentée par la formule générale (1) donnée ci-dessous et comportant au moins deux ligands multidentes, ou est un polymère conjugué contenant dans sa molécule un résidu d'un tel complexe métallique et un résidu d'un matériau transporteur de charges : 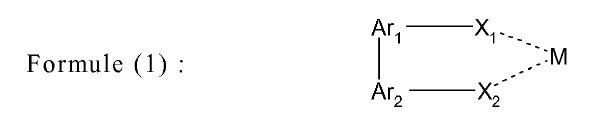 dans laquelle
- M représente un métal de transition ou un métal lanthanoïde,
- Ar₁ et Ar₂ représentent chacun, indépendamment, un cycle aromatique divalent, en option porteur de substituant(s),
- X₁ et X₂ représentent chacun, indépendamment, un atome d'oxygène ou de soufre ou un groupe de formule P(Ar₃)(Ar₄), où Ar₃ et Ar₄ représentent chacun, indépendamment, un cycle aromatique monovalent, en option porteur de substituant(s),
- et les traits discontinus de la formule représentent des liaisons de coordination entre un ligand multidente et le métal.

2. Matériau conforme à la revendication 1, lequel matériau est une composition comprenant un complexe métallique ayant une structure partielle représentée par la formule générale (1) et un matériau transporteur de charges qui est un polymère conjugué.

3. Matériau conforme à la revendication 1, lequel matériau est un polymère conjugué contenant dans sa molécule un résidu d'un complexe métallique ayant une structure partielle représentée par la formule générale (1) et un résidu d'un matériau transporteur de charges.

4. Matériau conforme à la revendication 2, dans lequel le matériau transporteur de charges est un polymère conjugué contenant dans sa molécule un résidu d'un complexe métallique ayant une structure partielle représentée par la formule générale (1) et un résidu d'un matériau transporteur de charges.

5. Matériau conforme à la revendication 3 ou 4, lequel matériau comporte en outre au moins un matériau choisi dans l'ensemble formé par les matériaux transporteurs de trous, les matériaux transporteurs d'électrons et les matériaux photo-émetteurs.

6. Matériau conforme à l'une des revendications 1 à 5, pour lequel le matériau transporteur de charges est choisi dans l'ensemble formé par une amine aromatique, un dérivé de carbazole, un dérivé de poly(para-phénylène), un dérivé d'oxadiazole, l'anthraquinodiméthane ou l'un de ses dérivés, la benzoquinone ou l'un de ses dérivés, la naphtoquinone ou l'un de ses dérivés, l'anthraquinone ou l'un de ses dérivés, le tétracyano-anthraquinodiméthane ou l'un de ses dérivés, un dérivé de fluorénone, le diphényl-dicyano-éthylène ou l'un de ses dérivés, un dérivé de diphénoquinone, un complexe métallique de 8-hydroxy-quinoléine ou un dérivé d'un tel complexe, un composé hôte servant dans des dispositifs électroluminescents organiques à bas poids moléculaire, un composé à injection et transport de charges, un poly-(vinyl-carbazole), un polymère comportant des cycles aromatiques dans sa chaîne principale et comportant, en tant que motif répété dans la chaîne principale, un groupe phénylène, en option porteur de substituant(s), ou un groupe dérivé du fluorène, du dibenzothiophène, du dibenzofurane ou du dibenzosilole, et un copolymère comportant de tels motifs.

7. Matériau conforme à l'une des revendications 1 à 5, dans lequel le polymère comporte une structure choisie dans l'ensemble formé par une amine aromatique, un dérivé de carbazole, un dérivé de poly(para-phénylène), un dérivé d'oxadiazole, l'anthraquinodiméthane ou l'un de ses dérivés, la benzoquinone ou l'un de ses dérivés, la naphtoquinone ou l'un de ses dérivés, l'anthraquinone ou l'un de ses dérivés, le tétracyano-anthraquinodiméthane ou l'un de ses dérivés, un dérivé de fluorénone, le diphényl-dicyano-éthylène ou l'un de ses dérivés, un dérivé de diphénoquinone, un complexe métallique de 8-hydroxy-quinoléine ou un dérivé d'un tel complexe, un composé hôte servant dans des dispositifs électroluminescents organiques à bas poids moléculaire, un composé à injection et transport de charges, un poly-(vinyl-carbazole), un polymère comportant des cycles aromatiques dans sa chaîne principale et comportant, en tant que motif répété dans la chaîne principale, un groupe phénylène, en option porteur de substituant(s), ou un groupe dérivé du fluorène, du dibenzothiophène, du dibenzofurane ou du dibenzosilole, et un copolymère comportant de tels motifs.

8. Matériau conforme à la revendication 6 ou 7, lequel matériau comporte un cycle benzénique, en option porteur de substituant(s), et/ou une structure partielle représentée par la formule générale (2) suivante : 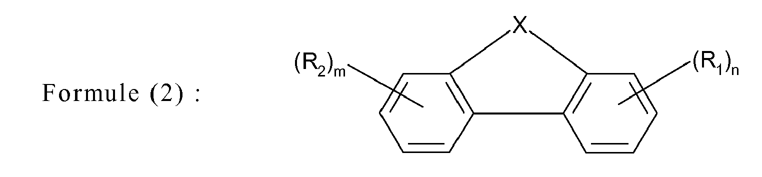 dans laquelle X représente un atome symbolisé par N, O, S, Se, B ou C ou une paire d'atomes symbolisée par C-C, O-C, S-C, N-C, Si-C, Si-Si, C=C ou Si=C, en option porteur(s) de substituant(s) en fonction de sa ou leur valence, R₁ et R₂ représentent chacun, indépendamment, un atome d'hydrogène ou d'halogène, un groupe alkyle, alcoxy ou aryle, ou une liaison à un autre atome, et les indices m et n sont chacun, indépendamment, un nombre entier valant de 0 à 4.

9. Matériau conforme à la revendication 8, dans lequel, dans la formule (2), -X- représente un ou deux chaînons symbolisé(s) par -O-, -S-, -Se-, -B(R₃₁)-, -Si(R₃₂)(R₃₃)-, -P(R₃₄)-, -P(R₃₆)(=O)-, -C(R₃₇)(R₃₈)-, -C(R₅₁)(R₅₂)-C(R₅₃)(R₅₄)-, -O-C(R₅₅)(R₅₆)-, S-C(R₅₇)(R₅₈)-, -N-C(R₅₉)(R₆₀)-, -Si(R₆₁)(R₆₂)-C(R₆₃)(R₆₄)-, -Si(R₆₅)(R₆₆)-Si(R₆₇)(R₆₈)-, -C(R₆₉)=C(R₇₀)-, -N(R₃₅)-, -N=C(R₇₁)-, ou -Si(R₇₂)=C(R₇₃)-, où les symboles R₃₁ à R₃₈ et R₅₁ à R₇₃ représentent chacun, indépendamment, un groupe alkyle, alcoxy, alkylthio, aryle, aryloxy, arylthio, aryl-alkyle, aryl-alcoxy, aryl-alkylthio, aryl-alcényle ou aryl-alcynyle, un groupe hétérocyclique monovalent ou un atome d'halogène.

10. Matériau conforme à la revendication 8, dans lequel, dans la formule (2), -X- représente un fragment de formule générale (3) suivante : 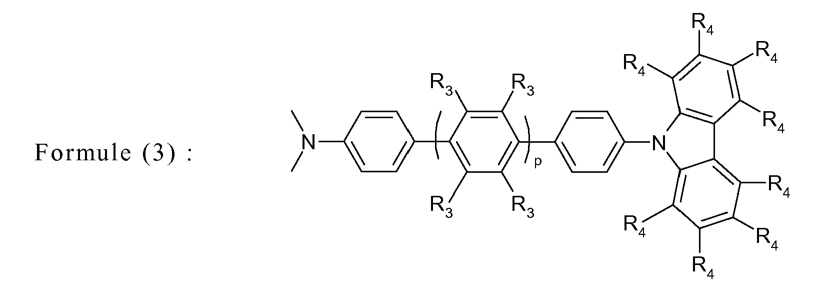 dans laquelle les symboles R₃ et R₄ représentent chacun, indépendamment, un atome d'halogène, un groupe alkyle, en option porteur de substituant(s) fluoro, ou un groupe alcoxy ou aryle, étant entendu qu'il n'est pas obligatoire qu'ils représentent la même entité partout dans un cycle, et l'indice p vaut 0 ou 1.

11. Matériau conforme à l'une des revendications 1 à 10, dans lequel le complexe métallique possède une structure représentée par la formule générale (1A) suivante : 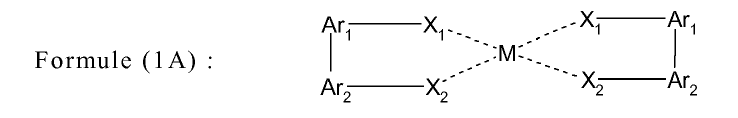 dans laquelle
- M représente un métal de transition ou un métal lanthanoïde,
- Ar₁ et Ar₂ représentent chacun, indépendamment, un cycle aromatique divalent, en option porteur de substituant(s),
- X₁ et X₂ représentent chacun, indépendamment, un atome d'oxygène ou de soufre ou un groupe de formule P(Ar₃)(Ar₄), où Ar₃ et Ar₄ représentent chacun, indépendamment, un cycle aromatique monovalent, en option porteur de substituant(s),
- et les traits discontinus de la formule représentent des liaisons de coordination entre un ligand multidente et le métal.

12. Matériau conforme à l'une des revendications 1 à 11, dans lequel le complexe métallique est représenté par l'une des formules suivantes (formules 5) : 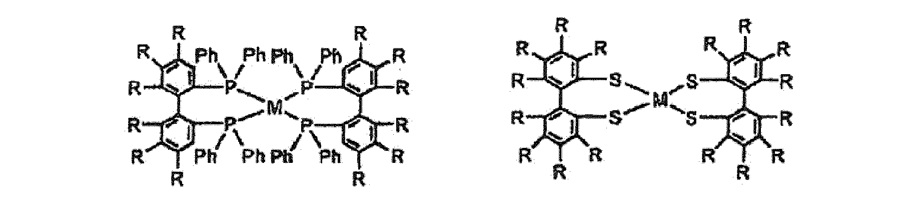 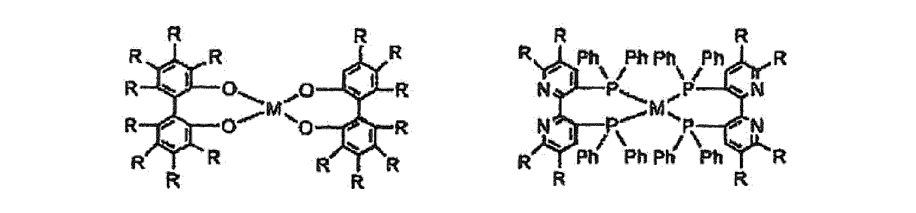 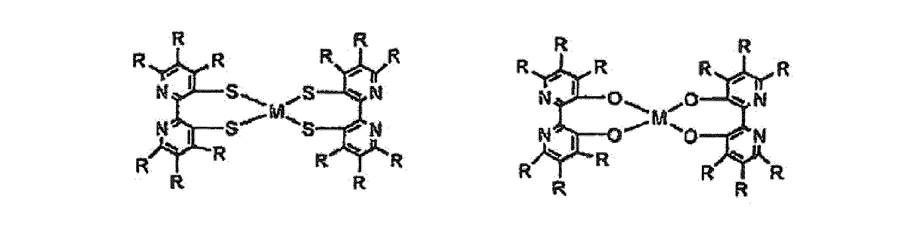 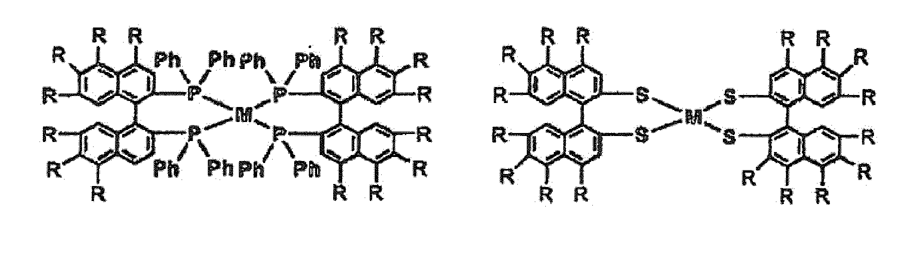 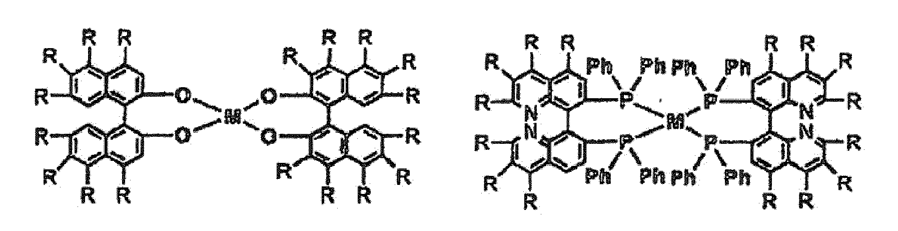 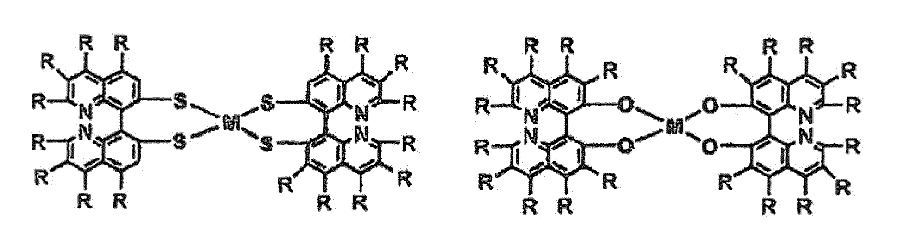 dans lesquelles formules M représente un atome d'un métal choisi dans l'ensemble constitué par les ruthénium, rhodium, palladium, tungstène, iridium, platine et or, et R représente une entité choisie dans l'ensemble formé par les atomes d'halogène, les groupes alkyle, alcoxy, alkylthio, aryle, aryloxy, arylthio, aryl-alkyle, aryl-alcoxy, aryl-alkylthio, acyle et acyloxy, les groupes de type amide, imide à caractère acide ou imine, les groupes amino à substituant(s), silyle à substituant(s), silyloxy à substituant(s), silyl-thio à substituant(s) ou silyl-amino à substituant(s), les groupes hétérocycliques monovalents, et les groupes hétéroaryloxy, hétéroarylthio, aryl-alcényle et aryl-éthynyle, étant entendu que les entités représentées par les symboles R peuvent être identiques ou différentes.

13. Composition liquide, **caractérisée en ce qu'**elle comprend un matériau conforme à l'une des revendications 1 à 12.

14. Composition liquide conforme à la revendication 13, laquelle composition liquide présente une viscosité de 1 à 100 mPa.s à 25 °C.

15. Film mince photo-émetteur, film mince conducteur ou film mince semi-conducteur organique, **caractérisé en ce qu'**il comprend un matériau conforme à l'une des revendications 1 à 12.

16. Dispositif photo-élecrique, **caractérisé en ce qu'**il comprend un matériau conforme à l'une des revendications 1 à 12.

17. Dispositif photo-élecrique conforme à la revendication 16, **caractérisé en ce que** ce dispositif photo-électrique comporte une couche contenant un complexe métallique ou un matériau conforme à l'une des revendications 1 à 12, placée entre des électrodes comprenant une anode et une cathode.

18. Dispositif photo-élecrique conforme à la revendication 16 ou 17, **caractérisé en ce que** ce dispositif photo-électrique comporte en outre une couche à transport de charges ou une couche à piégeage de charges, placée entre les électrodes comprenant une anode et une cathode.

19. Dispositif photo-élecrique conforme à l'une des revendications 16 à 18, **caractérisé en ce que** ce dispositif photo-électrique est un dispositif photo-émetteur.

20. Dispositif photo-élecrique conforme à l'une des revendications 16 à 18, **caractérisé en ce que** ce dispositif photo-électrique est un dispositif de commutation.

21. Dispositif photo-élecrique conforme à l'une des revendications 16 à 18, **caractérisé en ce que** ce dispositif photo-électrique est un dispositif de conversion photo-électrique.

22. Source lumineuse planar, afficheur à segments, afficheur à matrice de points, ou illumination, caractérisé(e) par l'utilisation d'un dispositif photo-émetteur conforme à la revendication 19, ou afficheur à cristaux liquides, **caractérisé par** l'utilisation, en guise d'éclairage par l'arrière, d'un dispositif photo-émetteur conforme à la revendication 19.

23. Afficheur à cristaux liquides comportant un circuit de commande de matrice active construit principalement à partir d'un dispositif de commutation conforme à la revendication 20.

24. Cellule solaire dans laquelle est utilisé un dispositif de conversion photo-électrique conforme à la revendication 21.
